# EUROPEAN PATENT SPECIFICATION

(11) **EP 2 647 685 B1**
(45) Date of publication and mention of the grant of the patent: **28.02.2018**
(21) Application number: 11845999.9
(22) Date of filing: 28.11.2011
(51) Int. Cl.: C09J 179/08, C09J 7/00, C09J 11/04, C09J 163/00, C09J 183/10, H01L 23/36, C08G 73/10, C08L 79/08, H01L 23/00, C08K 3/28, C08G 77/14

(54) **ADHESIVE COMPOSITION, ADHESIVE SHEET, AND SEMICONDUCTOR DEVICE USING THE ADHESIVE COMPOSITION OR THE ADHESIVE SHEET**
HAFTZUSAMMENSETZUNG, HAFTFOLIE UND HALBLEITERVORRICHTUNG MIT DER HAFTZUSAMMENSETZUNG ODER DER HAFTFOLIE
COMPOSITION ADHÉSIVE, FEUILLE ADHÉSIVE ET DISPOSITIF À SEMI-CONDUCTEURS UTILISANT LA COMPOSITION OU LA FEUILLE ADHÉSIVE

(30) Priority: 01.12.2010 JP 2010268017
(43) Date of publication of application: 09.10.2013
(73) Proprietor: Toray Industries, Inc., Tokyo 103-8666 (JP)
(72) Inventor: SHIMADA, Akira, Shiga 520-8558 (JP); SHINBA, Yoichi, Shiga, 520-8558 (JP); NONAKA, Toshihisa, Shiga, 520-8558 (JP)
(74) Representative: Hoefer & Partner Patentanwälte mbB
(86) International application number: PCT/JP2011/077305
(87) International publication number: WO 2012/073851

(56) References cited:
- WO-A1-2004/111148
- WO-A1-2011/089922
- JP-A- 2002 226 824
- JP-A- 2003 327 697
- JP-A- 2005 113 059
- JP-A- 2007 246 861
- JP-A- 2007 277 522
- JP-A- 2008 094 870
- JP-A- 2008 115 241
- JP-A- 2010 084 072
- JP-A- 2010 248 349

## Description

### Technical Field

The present invention relates to an adhesive composition used in electronic parts and electronic materials. More particularly, it relates to a highly thermally conductive adhesive composition used for heat dissipation materials and the like.

### Background Art

In recent years, due to technical advancement in performance of electronic equipment which becomes functionally advanced, lighter in weight and smaller in size, many electronic parts are densely mounted on an electronic circuit board. Since many of the electronic parts mounted serve as heating elements and the heat evolved from these electronic parts exerts an adverse influence on safety, performance and reliability of electronic equipment, the heat as a causative factor is a major problem. Thus, there has been an increase in demand for a highly thermally conductive adhesive that conducts heat evolved from electronic parts without loss from the parts and circuit boards to the housing and heat sinks.

As a material used for the highly thermally conductive adhesive, a resin composition prepared by adding high heat dissipation inorganic filler to a thermosetting resin such as an epoxy resin to increase the thermal conductivity has been proposed (See, for example, Patent Literature 1 and 2). Moreover, with regard to adhesives containing a polyimide resin or a polyimide silicone resin, an adhesive composition improved in thermal conductivity, heat resistance and adhesive properties by addition of high heat dissipation inorganic filler has been proposed (See, for example, Patent Literatures 3, 4, and 5).

### Citation List

### Patent Literature

Patent Literature 1: Japanese Patent Laid-Open No. 2008-266378
Patent Literature 2: Japanese Patent Laid-Open No. 2009-292881
Patent Literature 3: Japanese Patent Laid-Open No. 2010-84072
Patent Literature 4: Japanese Patent Laid-Open No. 2005-113059
Patent Literature 5: Japanese Patent Laid-Open No. 2007-277522

### Summary of Invention

### Technical Problem

However, there are problems such that when an inorganic filler is incorporated into the conventional composition in large quantities, the thermal conductivity is not significantly enhanced because the dispersibility of the filler in resins deteriorates, and the toughness and adhesive properties are remarkably lowered.

Thus, an object of the present invention is to provide an adhesive composition being capable of controlling the dispersibility of a thermally conductive filler, having high thermal conductivity and being excellent in adhesion to heating elements and heat sink materials.

### Solution to Problem

In order to solve the above-mentioned problems, the present invention is directed to an adhesive composition containing an organic-solvent-soluble polyimide (A), an epoxy resin (B) and a thermally conductive filler (C), an organic-solvent-soluble polyimide (A) containing a structure represented by the following general formula (1) as a component derived from a diamine, and the content of a thermally conductive filler (C) in the adhesive composition being not less than 60% by volume, the thermally conductive filler(C) includes two or more fillers differing in the average particle diameter and contains at least a filler with an average particle diameter of 6 µm or more and 15 µm or less and a filler with an average particle diameter of 30 µm or more, the content of the thermally conductive filler with an average particle diameter of 30 µm or more is not less than 10% by volume and not more than 35% by volume, and the average particle diameter is measured by a method of directly observing the particles with a SEM (scanning electron microscope) or a TEM (transmission electron microscope) and calculating a number average of particle diameter.

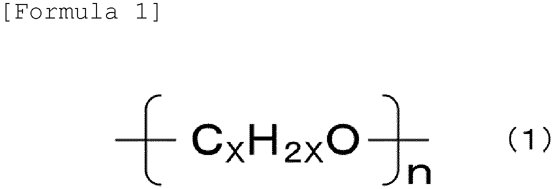

In general formula (1), X represents an integer of 1 to 10 inclusive and n represents an integer of 1 to 20 inclusive.

### Advantageous Effects of Invention

According to the present invention, there can obtain an adhesive composition being capable of controlling the dispersibility of a thermally conductive filler, having high thermal conductivity and being excellent in adhesion to substrates and insulation properties.

### Description of Embodiments

The adhesive composition according to the present invention is an adhesive composition containing an organic-solvent-soluble polyimide (A), an epoxy resin (B) and a thermally conductive filler (C), an organic-solvent-soluble polyimide (A) containing a structure represented by the following general formula (1) as a component derived from a diamine, and the content of a thermally conductive filler (C) in the adhesive composition being not less than 60% by volume, the thermally conductive filler(C) includes two or more fillers differing in the average particle diameter and contains at least a filler with an average particle diameter of 6 µm or more and 15 µm or less and a filler with an average particle diameter of 30 µm or more, the content of the thermally conductive filler with an average particle diameter of 30 µm or more is not less than 10% by volume and not more than 35% by volume, and the average particle diameter is measured by a method of directly observing the particles with a SEM (scanning electron microscope) or a TEM (transmission electron microscope) and calculating a number average of particle diameter.

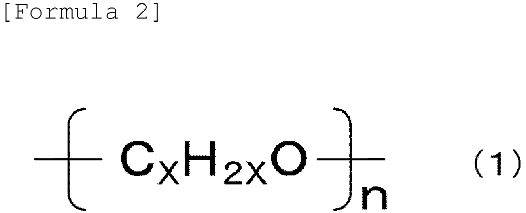

In general formula (1), X represents an integer of 1 to 10 inclusive and n represents an integer of 1 to 20 inclusive.

The organic-solvent-soluble polyimide (A) in the present invention refers to a material that allows 1 g or more of the polyimide to dissolve at 25°C in 100 g of any organic solvent among amide solvents such as N-methyl-2-pyrrolidone, N,N-dimethylacetamide, N,N-dimethylformamide, N-vinylpyrrolidone and N,N-diethylformamide and ether solvents such as γ-butyrolactone, methylmonoglyme, methyldiglyme, methyltriglyme, ethylmonoglyme, ethyldiglyme, ethylene glycol monomethyl ether, ethylene glycol monoethyl ether, propylene glycol monomethyl ether, propylene glycol monoethyl ether, ethylene glycol dimethyl ether and ethylene glycol diethyl ether.

Moreover, the organic-solvent-soluble polyimide (A) in the present invention is obtained mainly from the reaction of a tetracarboxylic acid dianhydride with a diamine and has a residue of the tetracarboxylic acid dianhydride and a residue of the diamine. In this context, the organic-solvent-soluble polyimide (A) in the present invention contains a structure represented by the above-mentioned general formula (1) in a diamine residue. Since an alkylene oxide skeleton is highly flexible, the adhesion of an adhesive composition obtained by using the polyimide with such a structure to a substrate is enhanced. From the viewpoint of enhancement in adhesion, the content of the diamine residue with a structure represented by the above-mentioned general formula (1) is preferably 20% by mole or more, more preferably 30% by mole or more, in all the diamine residues. Moreover, from the viewpoint of heat resistance, it is preferably 90% by mole or less, more preferably 80% by mole or less.

In the structure represented by general formula (1), specific examples of CₓH₂ₓ include a methylene group, an ethylene group, a propylene group, a butylene group, a pentylene group, a hexylene group, a nonylene group and the like. Moreover, it does not need to have a linear structure and in the case where it is a propylene group, for example, it may be either a n-propylene group or an i-propylene group. Moreover, in the case where it is a butylene group, it may be any one of a n-butylene group, an i-butylene group and a t-butylene group. The same holds true for an alkylene group with a greater number of carbon atoms than that.

Examples of the diamine with a structure represented by general formula (1) include polyoxyethylenediamine, polyoxypropylenediamine, polyoxybutylenediamine, bis(4-aminophenoxy)methane, 1,3-bis(4-aminophenoxy)propane, 1,4-bis(4-aminophenoxy)butane, 1,5-bis(4-aminophenoxy)pentane, trimethylene-bis(4-aminobenzoate), tetramethylene-bis(4-aminobenzoate), polytetramethylene oxide-bis(4-aminobenzoate), poly(tetramethylene/3-methyltetramethylene ether)glycolbis(4-aminobenzoate) and the like. Moreover, examples of products corresponding to these diamines include D230, D400, D2000, T403 and T5000 available from BASF Japan Ltd., Elastomer 250P, Elastomer 650P, Elastomer 1000P, Elastomer 1000, POREA SL-100A and CUA-4 available from IHARA CHEMICAL INDUSTRY CO., LTD., and the like. In this connection, the diamine with a structure represented by general formula (1) used in the present invention is not limited to the above-mentioned examples.

In the present invention, it is further preferred that the organic-solvent-soluble polyimide (A) have a residue of the diamine represented by the following general formula (2). By allowing it to have the diamine residue, the solubility of the organic-solvent-soluble polyimide in an organic solvent is enhanced. Moreover, since the polyimide skeleton is imparted with flexibility by virtue of a siloxane bond, the adhesion of an adhesive composition obtained by using the polyimide with such a structure to a substrate is enhanced. From the viewpoint of enhancement in adhesion, the content of the diamine residue represented by the following general formula (2) is preferably 5% by mole or more in all the diamine residues. Moreover, from the viewpoint of allowing the dispersibility affected by hydrophobicity of the siloxane bonded moiety to be enhanced, it is preferably 50% by mole or less.

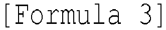

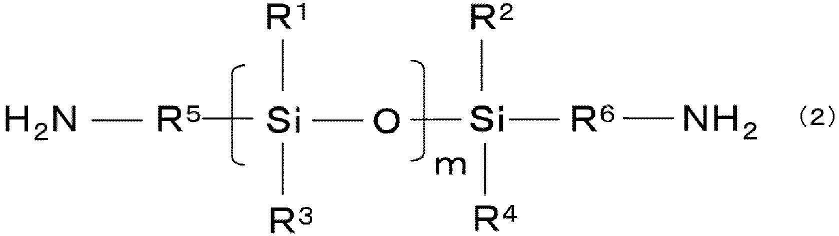

In general formula (2), m represents an integer of 1 to 30. R⁵ and R⁶ may be the same or different and represent an alkylene group with 1 to 30 carbon atoms or a phenylene group. R¹ to R⁴ each may be the same or different and represent an alkyl group with 1 to 30 carbon atoms, a phenyl group or a phenoxy group. Although the alkyl group with 1 to 30 carbon atoms is not particularly limited, preferred are a methyl group, an ethyl group, a propyl group and a butyl group. Moreover, although the alkylene group with 1 to 30 carbon atoms is not particularly limited, preferred are a methylene group, an ethylene group, a propylene group and a butylene group. In this connection, as in the case of the description of CₓH₂ₓ, the alkyl group and the alkylene group do not need to have a linear structure.

Specific examples of the diamine represented by general formula (2) include 1,1,3,3-tetramethyl-1,3-bis(4-aminophenyl)disiloxane, 1,1,3,3-tetraphenoxy-1,3-bis(4-aminoethyl)disiloxane, 1,1,3,3,5,5-hexamethyl-1,5-bis(4-aminophenyl)trisiloxane, 1,1,3,3-tetraphenyl-1,3-bis(2-aminoethyl)disiloxane, 1,1,3,3-tetraphenyl-1,3-bis(3-aminopropyl)disiloxane, 1,1,5,5-tetraphenyl-3,3-dimethyl-1,5-bis(3-aminopropyl)trisiloxane, 1,1,5,5-tetraphenyl-3,3-dimethoxy-1,5-bis(4-aminobutyl)trisiloxane, 1,1,5,5-tetraphenyl-3,3-dimethoxy-1,5-bis(5-aminopentyl)trisiloxane, 1,1,3,3-tetramethyl-1,3-bis(2-aminoethyl)disiloxane, 1,1,3,3-tetramethyl-1,3-bis(3-aminopropyl)disiloxane, 1,1,3,3-tetramethyl-1,3-bis(4-aminobutyl)disiloxane, 1,3-dimethyl-1,3-dimethoxy-1,3-bis(4-aminobutyl)disiloxane, 1,1,5,5-tetramethyl-3,3-dimethoxy-1,5-bis(2-aminoethyl)trisiloxane, 1,1,5,5-tetramethyl-3,3-dimethoxy-1,5-bis(4-aminobutyl)trisiloxane, 1,1,5,5-tetramethyl-3,3-dimethoxy-1,5-bis(5-aminopentyl)trisiloxane, 1,1,3,3,5,5-hexamethyl-1,5-bis(3-aminopropyl)trisiloxane, 1,1,3,3,5,5-hexaethyl-1,5-bis(3-aminopropyl)trisiloxane, 1,1,3,3,5,5-hexapropyl-1,5-bis(3-aminopropyl)trisiloxane and the like, although not limited thereto.

In the present invention, it is desirable that the weight-average molecular weight of the organic-solvent-soluble polyimide (A) be not less than 5,000 and not more than 500,000. In the case where two or more organic-solvent-soluble polyimides are incorporated, the weight-average molecular weight of at least one of these needs only to fall in the above-mentioned range. When the weight-average molecular weight is less than 5,000, the mechanical strength is remarkably lowered and the adhesive strength may be lowered. It is preferably not less than 10,000. On the other hand, when the weight-average molecular weight exceeds 500,000, the viscosity of the resin composition becomes higher and the dispersibility of the thermally conductive filler may be lowered. It is preferably not more than 100,000. In this connection, the weight-average molecular weight in the present invention is measured by a gel permeation chromatography method (GPC method) and calculated in terms of polystyrene.

The organic-solvent-soluble polyimide (A) in the present invention may contain, in addition to the above-mentioned diamine residues, another diamine residue without impairing the effect of the present invention. Examples thereof include a residue of a diamine compound exemplified by diamines containing one benzene ring such as 1,4-diaminobenzene, 1,3-diaminobenzene, 2,4-diaminotoluene and 1,4-diamino-2,5-dihalogenobenzene, diamines containing two benzene rings such as bis(4-aminophenyl) ether, bis(3-aminophenyl) ether, bis(4-aminophenyl) sulfone, bis(3-aminophenyl) sulfone, bis(4-aminophenyl)methane, bis(3-aminophenyl)methane, bis(4-aminophenyl) sulfide, bis(3-aminophenyl) sulfide, 2,2-bis(4-aminophenyl)propane, 2,2-bis(3-aminophenyl)propane, 2,2-bis(4-aminophenyl)hexafluoropropane, o-dianisidine, o-tolidine and tolidine sulfonic acids, diamines containing three benzene rings such as 1,4-bis(4-aminophenoxy)benzene, 1,4-bis(3-aminophenoxy)benzene, 1,4-bis(4-aminophenyl)benzene, 1,4-bis(3-aminophenyl)benzene, α,α'-bis(4-aminophenyl)-1,4-diisopropylbenzene and α,α'-bis(4-aminophenyl)-1,3-diisopropylbenzene, diamines containing four or more benzene rings such as 2,2-bis[4-(4-aminophenoxy)phenyl]propane, 2,2-bis[4-(4-aminophenoxy)phenyl]hexafluoropropane, 2,2-bis[4-(4-aminophenoxy)phenyl] sulfone, 4,4'-(4-aminophenoxy)biphenyl, 9,9-bis(4-aminophenyl)fluorene and 5,10-bis(4-aminophenyl)anthracene and the like. In this connection, examples of another diamine residue are not limited thereto.

No particular restriction is put on an acid dianhydride residue which the organic-solvent-soluble polyimide (A) in the present invention has and examples thereof include a residue of an acid dianhydride such as pyromellitic acid dianhydride (PMDA), oxydiphthalic acid dianhydride (ODPA), 3,3',4,4'-benzophenonetetracarboxylic acid dianhydride (BTDA), 3,3',4,4'-biphenyltetracarboxylic acid dianhydride (BPDA), 3,3',4,4'-diphenylsulfonetetracarboxylic acid dianhydride (DSDA), 2,2'-bis[(dicarboxyphenoxy)phenyl]propane dianhydride (BSAA), 4,4'-hexafluoroisopropylidenediphthalic acid anhydride (6FDA), 1,2-ethylenebis(anhydrotrimellitate) (TMEG) and the like. In this connection, examples of the acid dianhydride residue are not limited thereto.

Among the above-mentioned examples, it is preferred that the residue of the tetracarboxylic acid dianhydride and the residue of the diamine have a structure in which 1) there are few benzene rings, 2) the molecular weight is large and the volume is bulky or 3) there are many crooked parts such as an ether linkage. By allowing them to have such a structure, the interaction between molecular chains becomes weak and the solubility of the organic-solvent-soluble polyimide in an organic solvent is enhanced.

The organic-solvent-soluble polyimide (A) in the present invention may be composed only of a polyimide structural unit or may be a copolymer with another structure as a copolymerization component in addition to the polyimide structural unit. Moreover, a precursor of the polyimide structural unit (polyamic acid structure) may be incorporated. Moreover, it may be a mixture thereof. Furthermore, a polyimide represented by another structure may be mixed with any of these. In the case where a polyimide represented by another structure is mixed with that, it is preferred to allow the organic-solvent-soluble polyimide (A) to be incorporated in 50% by mole or more of the content. It is preferred that the kind and amount of the structure employed for copolymerization or mixing be selected without impairing the effect of the present invention.

The method of synthesizing the organic-solvent-soluble polyimide (A) used in the present invention is not particularly limited and the polyimide is synthesized by known methods with a diamine and a tetracarboxylic acid dianhydride. For example, a method of allowing a tetracarboxylic acid dianhydride and a diamine compound (a portion thereof may be substituted with an aniline derivative) to undergo a reaction at a low temperature, a method of preparing a diester by a reaction of a tetracarboxylic acid dianhydride and an alcohol and then allowing it to react with a diamine (a portion thereof may be substituted with an aniline derivative) in the presence of a condensation agent, a method of preparing a diester by a reaction of a tetracarboxylic acid dianhydride and an alcohol and then allowing two carboxyl groups remaining to be acid chlorinated and allowing it to react with a diamine (a portion thereof may be substituted with an aniline derivative) and the like are utilized to prepare a polyimide precursor and a known imidization method may be utilized to synthesize the polyimide from the precursor.

The adhesive composition according to the present invention contains an epoxy resin (B). The adhesive composition contains an epoxy resin, in which since the viscosity of the adhesive composition becomes low until the B-stage, the ease of thermocompression bonding between a material prepared by forming the adhesive composition into a sheet (adhesive sheet) and a substrate is enhanced. Moreover, since a crosslinking reaction proceeds three-dimensionally by the hardening reaction, the mechanical strength after adhesion, the heat resistance and the adhesion to a substrate are enhanced.

Although no particular limitation is put on the epoxy resin (B) used in the present invention, from the viewpoints of enhancing the rheological properties at high temperatures and the mechanical strength after hardening and lowering the thermal expansion coefficient, a crystalline epoxy resin is preferred. The crystalline epoxy resin refers to an epoxy resin with a mesogenic skeleton such as a biphenyl group, a naphthalene skeleton, an anthracene skeleton, a phenyl benzoate group and a benzanilide group. Examples of the product corresponding to such an epoxy resin include JERYX4000, JERYX4000H, JERYX8800, JERYL6121H, JERYL6640, JERYL6677 and JERYX7399 available from Mitsubishi Chemical Corporation, NC3000, NC3000H, NC3000L and CER-3000L available from Nippon Kayaku Co., Ltd., YSLV-80XY and YDC1312 available from NIPPON STEEL CHEMICAL CO., LTD., HP4032D available from DIC Corporation, and the like.

Moreover, it is preferred that the epoxy resin (B) used in the present invention be an epoxy resin with a fluorene skeleton from the viewpoints of enhancing the dispersibility of a thermally conductive filler (C) and enhancing the insulation properties after hardening. Examples of such an epoxy resin include PG100, CG500, CG300-M2, EG200 and EG250 available from Osaka Gas Chemical Co., Ltd., and the like.

Moreover, it is preferred that the epoxy resin (B) used in the present invention be an epoxy resin which is liquid at room temperature from the viewpoints of flexibility at the B-stage and adhesion strength to a substrate. In this context, the epoxy resin which is liquid refers to an epoxy resin with a viscosity of 150 Pa·s or less at 25°C under 1.013 × 10⁵ N/m² and examples thereof include a bisphenol A based epoxy resin, a bisphenol F based epoxy resin, an alkylene oxide-modified epoxy resin, a glycidyl amine based epoxy resin and the like. Examples of the product corresponding to such an epoxy resin include JER827, JER828, JER806, JER807, JER801N, JER802, JER604, JER630 and JER630LSD available from Mitsubishi Chemical Corporation, EPICLON840S, EPICLON850S, EPICLON830S, EPICLON705 and EPICLON707 available from DIC Corporation, YD127, YD128, PG207N and PG202 available from NIPPON STEEL CHEMICAL Co., Ltd., and the like.

Moreover, the epoxy resin (B) used in the present invention may be composed of one kind thereof and may be used in combination of two or more kinds thereof. The content of the epoxy resin (B) is preferably not less than 20 parts by weight and not more than 800 parts by weight relative to 100 parts by weight of the organic-solvent-soluble polyimide (A). From the viewpoint of ease of thermocompression bonding of an adhesive sheet at the B-stage to a substrate, it is more preferably not less than 50 parts by weight. Moreover, from the viewpoints of lowering the cross-linking density of the epoxy resin after hardening and enhancing the toughness of the adhesive composition and the adhesion strength to a substrate, it is more preferably not more than 500 parts by weight.

Furthermore, a hardening accelerator may be incorporated into the adhesive composition according to the present invention if necessary. By combining an epoxy resin and a hardening accelerator, it is made possible to accelerate the hardening of the epoxy resin and to harden it in a short time. As the hardening accelerator, imidazoles, polyhydric phenols, acid anhydrides, amines, hydrazides, polymercaptans, Lewis acid-amine complexes, latent hardening accelerators and the like may be used. Among these, imidazoles, polyhydric phenols and latent hardening accelerators which are excellent in storage stability and heat resistance of the cured product are preferably used. These may be used alone or two or more kinds thereof may be mixed to use.

Examples of the imidazoles include Curezol 2MZ, Curezol 2PZ, Curezol 2MZ-A and Curezol 2MZ-OK (the above are trade names, available from SHIKOKU CHEMICALS CORPORATION). Examples of the polyhydric phenols include SUMILITE RESIN PR-HF3 and SUMILITE RESIN PR-HF6 (the above are trade names, available from SUMITOMO BAKELITE CO., LTD.), KAYAHARD KTG-105 and KAYAHARD NHN (the above are trade names, available from Nippon Kayaku Co., Ltd.), PHENOLITE TD2131, PHENOLITE TD2090, PHENOLITE VH-4150, PHENOLITE KH-6021, PHENOLITE KA-1160 and PHENOLITE KA-1165 (the above are trade names, available from DIC Corporation) and the like. Moreover, examples of the latent hardening accelerators include a dicyandiamide based latent hardening accelerator, an amine adduct based latent hardening accelerator, an organic acid hydrazide based latent hardening accelerator, an aromatic sulfonium salt based latent hardening accelerator, a microcapsulated latent hardening accelerator and a UV curable latent hardening accelerator.

Examples of the dicyandiamide based latent hardening accelerator include DICY7, DICY15 and DICY50 (the above are trade names, available from JAPAN EPOXY RESINS CO., LTD.), AJICURE AH-154 and AJICURE AH-162 (the above are trade names, available from Ajinomoto Fine-Techno Co., Inc.) and the like. Examples of the amine adduct based latent hardening accelerator include AJICURE PN-23, AJICURE PN-40, AJICURE MY-24 and AJICURE MY-H (the above are trade names, available from Ajinomoto Fine-Techno Co., Inc.), Fujicure FXR-1030 (trade name, available from FUJI KASEI CO., LTD.) and the like. Examples of the organic acid hydrazide based latent hardening accelerator include AJICURE VDH and AJICURE UDH (the above are trade names, available from Ajinomoto Fine-Techno Co., Inc.) and the like. Examples of the aromatic sulfonium salt as the aromatic sulfonium salt based latent hardening accelerator include San-Aid SI100, San-Aid SI150 and San-Aid SI180 (the above are trade names, available from SANSHIN CHEMICAL INDUSTRY CO., LTD.) and the like. Examples of the microcapsulated latent hardening accelerator include a material prepared by capsulating each of the above-mentioned hardening accelerators with a vinyl compound, an urea compound and a thermoplastic resin. Of these, examples of the microcapsulated latent hardening accelerator prepared by treating the amine adduct based latent hardening accelerator with an isocyanate include NOVACURE HX-3941HP, NOVACURE HXA3922HP, NOVACURE HXA3932HP and NOVACURE HXA3042HP (the above are trade names, available from ASAHI KASEI CHEMICALS CORPORATION) and the like. Moreover, examples of the UV curable latent hardening accelerator include OPTOMER SP and OPTOMER CP (available from ADEKA CORPORATION) and the like.

In the case where the hardening accelerator is incorporated into the adhesive composition, the content thereof is preferably not less than 0.1 part by weight and not more than 35 parts by weight relative to 100 parts by weight of the epoxy resin (B).

The adhesive composition according to the present invention contains a thermally conductive filler (C). In the present invention, the thermally conductive filler refers to a filler with a thermal conductivity of 2 W/m·K or more at 25°C. After a sintered body with a thickness of about 1 mm and a porosity of 10% or less is prepared, the thermal conductivity of the filler may be measured and determined in accordance with JIS R1611(2010). No particular limitation is put on the filler as long as it is a filler like this and examples thereof include inorganic fillers such as carbon black, silica, magnesium oxide, zinc oxide, alumina, aluminum nitride, boron nitride, silicon carbide and silicon nitride based fillers, metal fillers such as copper, aluminum, magnesium, silver, zinc, iron and lead based fillers, and the like. These fillers may be used alone or in combination of plural fillers. Moreover, no particular limitation is put on the shape of the filler and examples thereof include a perfectly spherical shape, a spherical shape, a scalelike shape, a flaky shape, a foillike shape, a fibrous shape, a needlelike shape and the like. From the viewpoint of allowing the thermally conductive filler to be densely incorporated, preferred is a filler with a perfectly spherical shape.

In the present invention, the content of the thermally conductive filler (C) is not less than 60% by volume in the adhesive composition. Since the content is not less than 60% by volume, the thermal conductivity of the adhesive composition is allowed to become high. It is more preferably not less than 65% by volume. In this connection, in the case where the adhesive composition is used as a sheet as described below, the content of the thermally conductive filler (C) in the sheet is not less than 60% by volume, more preferably not less than 65% by volume.

The content by volume of the filler is determined by calculating the content by volume of each ingredient from the content by weight and specific gravity of each ingredient contained in the adhesive composition. In this context, with regard to calculating the percentage content by volume (vol. %) of the filler in the adhesive composition and the sheet, in the case where the adhesive composition and the sheet contain a solvent, the solvent shall not be included in the calculation. That is, the total of the content by volume of the ingredients excluding the solvent among ingredients contained in the adhesive composition or the sheet is employed as the denominator and the percentage content by volume of the filler is calculated.

Examples of the method of calculating the percentage content by volume of the filler from the cured product of the sheet include a method of utilizing the following thermogravimetric analysis, although not limited thereto. Examples thereof include a method of first allowing the cured product of the sheet to be heated to 600 to 900°C, allowing the resin content to decompose and volatilize, measuring the filler weight contained, further calculating the weight of the resin, and then calculating the volume by dividing the weight by the specific gravity of the filler or resin to calculate it.

According to the present invention two or more fillers differing in the average particle diameter are used in combination as the thermally conductive filler (C). The average particle diameter of at least one of the fillers is not less than 6 µm. Since a thermally conductive filler with an average particle diameter of 6 µm or more is incorporated, a high thermal conductivity is attained. Moreover, it is desirable that the average particle diameter be not more than 100 µm. By allowing the average particle diameter to be not more than 100 µm, it is made possible to decrease the surface roughness of the adhesive resin composition at the B-stage and to further increase the adhesive strength.

Moreover, the content of the thermally conductive filler with an average particle diameter of 6 µm or more is, from the viewpoint of enhancement in the thermal conductivity, preferably not less than 40% by volume, more preferably not less than 50% by volume, in the adhesive composition. In this connection, in the case where the adhesive composition is used as a sheet as described below, the content of the thermally conductive filler with an average particle diameter of 6 µm or more in the sheet is preferably not less than 40% by volume, more preferably not less than 50% by volume.

Accordingly, the thermally conductive filler (C) used in the present invention includes two or more fillers differing in the average particle diameter and contains at least a filler with an average particle diameter of 6 µm or more and 15 µm or less (C-1) and a filler with an average particle diameter of 30 µm or more, preferably 40 µm or more (C-2). With regard to the average particle diameter of the filler (C-1), as the lower limit, it is preferably 8 µm or more and as the upper limit, it is preferably 12 µm or less, further preferably 10 µm or less. Moreover, although the upper limit of the average particle diameter of the filler (C-2) is not particularly limited, it is preferably 90 µm or less, more preferably 70 µm or less, further preferably 50 µm or less. Since thermally conductive fillers are incorporated in combination like this, a higher thermal conductivity is attained.

Moreover, the content of the thermally conductive filler with an average particle diameter of 30 µm or more, preferably 40 µm or more is, from the viewpoint of enhancement in the thermal conductivity, not less than 10% by volume, preferably not less than 20% by volume. Moreover, from the viewpoint of enhancing the withstand voltage, it is not more than 35% by volume, preferably not more than 30% by volume.

Moreover, as a thermally conductive filler combinedly used with the thermally conductive filler with an average particle diameter of 6 µm or more, in addition to those described above, it is desirable that a filler with an average particle diameter of less than 6 µm be incorporated. This enables the fillers with a small particle diameter to disperse throughout the empty space between the fillers with a large particle diameter, the thermally conductive filler to be more densely incorporated into the adhesive composition, and the thermal conductivity of the adhesive composition to be enhanced. Although the lower limit of the average particle diameter is not particularly limited, it is preferably 0.01 µm or more, further preferably 0.1 µm or more.

In this connection, the average particle diameter in the present invention refers to an average particle diameter of primary particles kept from clumping together and in the case where the primary particles clump together, it refers to a particle diameter of the aggregate. Examples of a method of measuring the average particle diameter of the thermally conductive filler in a paste composition include a method of directly observing the particles with a SEM (scanning electron microscope) or a TEM (transmission electron microscope) and calculating a number average of particle diameter.

As the filler with an average particle diameter of 6 µm or more, preferred are alumina, boron nitride, aluminum nitride, zinc oxide, magnesium oxide, silica and the like. It is because these fillers have high thermal conductivity and are highly effective in increasing the thermal conductivity of the adhesive resin composition.

Moreover, it is preferred that the thermally conductive filler (C) used in the present invention be a filler that the pH of the liquid prepared when 10 g of the thermally conductive filler is added to 100 g of water is not more than 6.0. Hereinafter, such a filler is sometimes referred to simply as "a thermally conductive filler with a pH of 6.0 or less". Since the organic-solvent-soluble polyimide (A) in the adhesive composition has a residue of a basic functional group such as an amine, the acid-base interactions enable the dispersibility of the thermally conductive filler to be enhanced. This causes the adhesive force of the adhesive composition to a substrate after hardening to be enhanced. The thermally conductive filler with a pH of 6.0 or less is not limited by the kind of the filler itself and examples thereof include a filler on the surface of which many acidic functional groups such as carboxyl groups and hydroxyl groups are present, a filler prepared by subjecting the surface thereof to a treatment with a higher fatty acid or a silane coupling agent, and the like. Examples of the filler on the surface of which many acidic functional groups such as carboxyl groups and hydroxyl groups are present include carbon black and alumina. From the viewpoint of insulation properties, preferred is alumina. Such an alumina particle is exemplified by AO802, AO809, AO820, AO502, AO509 and AO520 available from Admatechs Co., Ltd., DAW-03, DAM-03, DAW-05, DAM-05, DAW-07, DAM-07, DAW-45, DAM-45, DAW-70 and DAM-70 available from DENKI KAGAKU KOGYO CO.,LTD., and the like.

Moreover, the thermally conductive filler with a pH of 6.0 or less and other fillers than that may be mixed to use. In the case where they are mixed to use, the content of the thermally conductive filler with a pH of 6.0 or less is preferably not less than 40% by volume in the adhesive composition. It is more preferably not less than 50% by volume. Since the content is not less than 40% by volume, it is made possible to enhance the dispersibility of the thermally conductive filler and to attain higher thermal conductivity. In this connection, in the case where the adhesive composition is used as a sheet as described below, the content of the thermally conductive filler with a pH of 6.0 or less in the sheet is preferably not less than 40% by volume, more preferably not less than 50% by volume.

The adhesive composition according to the present invention may contain a surfactant if necessary and it is made possible to enhance wettability to cover a substrate. Moreover, a silane coupling agent such as methylmethacryloxy dimethoxysilane and 3-aminopropyl trimethoxysilane, a titanate chelating agent and the like may be incorporated into the adhesive composition in 0.5 to 10% by weight content.

Next, a method of forming the adhesive composition according to the present invention into a sheet will be described. In order to form the adhesive composition according to the present invention into a sheet, for example, a material in the condition of being a varnish prepared by mixing the adhesive composition into a solvent may be applied on a support, dried and formed into a sheet.

The solvent used herein needs only to be appropriately selected from solvents capable of dissolving the above-mentioned ingredients and examples thereof include ketone solvents such as acetone, methyl ethyl ketone, methyl isobutyl ketone, cyclopentanone and cyclohexanone, ether solvents such as 1,4-dioxane, tetrahydrofuran and diglyme, glycol ether solvents such as methyl cellosolve, ethyl cellosolve, propylene glycol monomethyl ether, propylene glycol monoethyl ether, propylene glycol monobutyl ether and diethylene glycol methyl ethyl ether, and as other examples, benzyl alcohol, propanol, N-methylpyrrolidone, γ-butyrolactone, ethyl acetate, N,N-dimethylformamide and the like. Above all, in the case where a solvent with a boiling point of 120°C or less under atmospheric pressure is incorporated, since deliquoring can be effected at a low temperature in a short time, sheet forming is facilitated.

Although the method of making the adhesive composition according to the present invention into a material in the condition of being a varnish is not particularly limited, preferred is a method of mixing the organic-solvent-soluble polyimide (A), the epoxy resin (B), the thermally conductive filler (C) and other ingredients incorporated as needed in the above-mentioned solvent with a propeller agitator, a homogenizer, a kneader or the like and then mixing them with a bead mill, a ball mill, a three roll mill or the like from the viewpoint of enhancing the dispersibility of the thermally conductive filler (C).

Examples of the method of applying a varnish to a support include spin coating with a spinner, spray coating, roll coating, screen printing and a coating method with a blade coater, a die coater, a calender coater, a meniscus coater, a bar coater, a roll coater, a comma roll coater, a gravure coater, a screen coater, a slit die coater or the like.

Although a roll coater, a comma roll coater, a gravure coater, a screen coater, a slit die coater or the like may be used as a coating machine, a slit die coater is preferably used since there is little volatilization of the solvent on coating and stable coating properties are attained. Although the thickness of a sheet-formed adhesive composition (an adhesive sheet) is not particularly limited, from the viewpoints of insulation properties such as the withstand voltage and heat dissipation properties, it is preferably in the range of 20 to 200 µm.

For drying, an oven, a hot plate, infrared rays or the like may be used. The drying temperature and the drying time need only to be in a range where the organic solvent can be volatilized and it is preferred that such a range in which the adhesive sheet is in a state of being uncured or semi-cured (a state of being at the B-stage) be appropriately set. Specifically, it is preferred that the adhesive sheet be maintained in the range of 40°C to 120°C for 1 minute to several tens of minutes. Moreover, several temperatures may be combinedly used and the drying temperature may be gradually increased, and for example, a heat treatment may be carried out at 70°C, 80°C and 90°C for 1 minute each.

Although the support is not particularly limited, usually commercially available various films such as a polyethylene terephthalate (PET) film, a polyphenylene sulfide film and a polyimide film are usable.

The combined surface of the support to the adhesive composition may be subjected to a surface treatment with silicone, a silane coupling agent, an aluminum chelating agent, polyurea and the like in order to enhance the adhesion and the release properties. Moreover, although the thickness of the support is not particularly limited, from the viewpoint of usability, it is preferably in the range of 10 to 100 µm.

Moreover, the adhesive sheet may have a protective film to protect the surface thereof. This enables the adhesive sheet surface to be protected from contaminants such as garbage and dust in the air.

Examples of the protective film include a polyethylene film, a polypropylene (PP) film, a polyester film and the like. It is preferred that the protective film have a small adhesive force to the adhesive sheet.

Next, a method of bonding substrates and members utilizing the adhesive composition or adhesive sheet according to the present invention will be described with reference to examples. It is preferred to make the adhesive composition into a material in the condition of being a varnish as above to use. First, using an adhesive composition, varnish, an adhesive composition coating is formed on one surface of a substrate or a member to be bonded. Examples of the substrate and the member include a thin plate made of metallic material such as copper and SUS, a semiconductor device (a lead frame part thereof and the like) to be bonded thereto, and the like. Examples of a coating method of the adhesive composition, varnish include spin coating with a spinner, spray coating, roll coating, screen printing or the like. Moreover, although the coating thickness varies with the coating procedure, the solid content of the resin composition, the viscosity and the like, it is preferred that the varnish be applied so as to allow the thickness after drying to be usually not less than 50 µm and not more than 300 µm. Then, the substrate on which the adhesive composition, varnish is applied is dried to obtain an adhesive composition coating. On drying, an oven, a hot plate, infrared rays or the like may be used. The drying temperature and the drying time need only to be in a range where the organic solvent can be volatilized and it is preferred that such a range in which the adhesive resin composition coating is in a state of being uncured or semi-cured be appropriately set. Specifically, it is preferred to be carried out in the range of 50 to 150°C for 1 minute to several hours.

On the other hand, in the case where the adhesive sheet has a protective film, it is stripped off. The adhesive sheet and a substrate are placed so as to stand opposite each other and bonded together by thermocompression bonding. The thermocompression bonding may be carried out by a hot pressing treatment, a heat laminating treatment, a heat vacuum laminating treatment or the like. The bonding temperature is preferably not less than 40°C from the viewpoints of adhesion to a substrate and embedability. Moreover, in the case where the temperature becomes higher on bonding, since the time required for hardening the adhesive sheet becomes short and the usability is decreased, the bonding temperature is preferably not more than 250°C. In the case where the adhesive sheet has a support, the support may be stripped off before bonding and may be stripped off at any point of time during the thermocompression bonding process or after thermocompression bonding.

The substrate on which the adhesive composition coating thus obtained is formed is bonded to a substrate or other members by thermocompression. The thermocompression bonding temperature needs only to be not less than the glass transition temperature of the resin and is preferably in the temperature range of 100 to 400°C. Moreover, the pressure on compression bonding is preferably in the range of 0.01 to 10 MPa. The time is preferably 1 second to several minutes.

After thermocompression bonding, heat in the 120°C to 400°C range is applied to give a cured coating. This heat treatment is carried out by setting temperatures and gradually increasing the temperature or setting a temperature range and continuously increasing the temperature for 5 minutes to 5 hours. In one case, the heat treatment is carried out at 130°C and 200°C for 30 minutes each. Moreover, examples thereof include a method of linearly increasing the temperature over a 2-hour period from room temperature to 250°C. In this case, the heating temperature is preferably a temperature of 150°C or more and 300°C or less, and further preferably a temperature of 180°C or more and 250°C or less.

With regard to a bonded body thus obtained by being subjected to thermocompression bonding, it is desirable that the peel strength be not less than 2 N/mm from the viewpoint of adhesion reliability. That of 5 N/mm or more is more desirable.

Although the thickness of the cured coating may be appropriately set, it is preferably not less than 50 µm and not more than 300 µm.

Next, the application of the adhesive composition in the present invention will be described with reference to an example, but the application of the adhesive composition according to the present invention is not limited to the following.

The adhesive composition according to the present invention can be widely used as an adhesive for a semiconductor device and is suitably used especially for power IC packaging. Power IC refers to an IC for power control and it is an IC in which the SiC semiconductor as well as the conventional Si semiconductor is used, it is an IC driven at higher temperatures compared to an IC for computing, and it may be an IC with great calorific value. An adhesive layer is formed by sticking an adhesive sheet to a radiating fin made of metallic substrate or by applying a varnish of an adhesive composition thereto and drying it. Afterward, the radiating fin is bonded to a lead frame, which is made of copper, of a semiconductor device on which the power IC is mounted by thermocompression to give the power IC packaging. In this connection, the semiconductor device in the present invention refers to devices in general which can function by utilizing characteristics of a semiconductor element as well as a device in which a semiconductor element is connected to a substrate or a device in which semiconductor elements or substrates are connected each other, and an electrooptic device, a semiconductor circuit board and electronic parts containing them are all included in the semiconductor device.

### Examples

Hereinafter, the present invention will be described in detail on the basis of Examples, but the present invention is not limited thereto. In this connection, the details of raw materials represented by the abbreviation in each Example will be shown below.

### <Raw materials for polyimide>

ODPA: 4,4'-oxydiphthalic acid dianhydride (available from Manac, Inc.)
BAHF: 2,2-bis(3-amino-4-hydroxyphenyl)hexafluoropropane (available from AZ Electronic Materials Co., Ltd.)
MBAA: [bis(4-amino-3-carboxy)phenyl]methane (available from Wakayama Seika Kogyo Co., Ltd.)
SiDA: bis(3-aminopropyl)tetramethyldisiloxane (available from Shin-Etsu Chemical Co., Ltd.)
MAP: 3-aminophenol (available from TOKYO CHEMICAL INDUSTRY CO., LTD.)
Elastomer 1000: polytetramethylene oxide-di-para-aminobenzoate
D-400: polyoxypropylenediamine (available from BASF Japan Ltd., trade name "Jeffamine" D-400, the material represented by general formula (1) wherein n = 5 to 7).

### <Epoxy resin>

EPICLON850S: a bisphenol A based liquid epoxy resin
EXA-4850-150: an oligomer type modified bisphenol A based liquid epoxy resin (available from DIC Corporation).

NC3000: an epoxy resin with a biphenyl skeleton (available from Nippon Kayaku Co., Ltd.)
PG100: an epoxy resin with a fluorene skeleton (available from Osaka Gas Chemical Co., Ltd.)

### <Thermally conductive filler>

DAW-45: alumina particles (average particle diameter: 45 µm, thermal conductivity: 26 W/m·K) (available from DENKI KAGAKU KOGYO CO., LTD.)
AO820: alumina particles (average particle diameter: 20 µm, thermal conductivity: 20 W/m·K) (available from Admatechs Co., Ltd.: brand name Admatechs)
AO509: alumina particles (average particle diameter: 9 µm, thermal conductivity: 20 W/m·K) (available from Admatechs Co., Ltd.: brand name Admatechs)
AO502: alumina particles (average particle diameter: 0.7 µm, thermal conductivity: 20 W/m·K) (available from Admatechs Co., Ltd.: brand name Admatechs)
FAN-30: aluminum nitride particles (average particle diameter: 30 µm, thermal conductivity: 170 W/m·K) (available from Furukawa Densi Co., Ltd.)
FAN-50: aluminum nitride particles (average particle diameter: 50 µm, thermal conductivity: 170 W/m·K) (available from Furukawa Densi Co., Ltd.)
FAN-05: aluminum nitride particles (average particle diameter: 5 µm, thermal conductivity: 170 W/m·K) (available from Furukawa Densi Co., Ltd.)
HP-40: boron nitride particles (average particle diameter: 8 µm, thermal conductivity: 40 W/m·K) (available from MIZUSHIMA FERROALLOY CO., LTD)
MBN-010T: boron nitride particles (average particle diameter: 0.9 µm, thermal conductivity: 40 W/m·K) (available from Mitsui Chemicals Co., Ltd.).

### <Hardening accelerator>

2PZ: 2-phenylimidazole.

### <Solvent>

γBL: γ-butyrolactone.

The evaluation method in each of Examples, Reference Examples and Comparative Examples will be shown below.

### <Molecular weight of polyimide synthesized>

By using a solution with a solid content of 0.1% by weight prepared by dissolving polyimide in NMP and the GPC apparatus Waters2690 (available from Waters Corp.) with the following configuration, a weight-average molecular weight in terms of polystyrene was calculated. With regard to the conditions for GPC measurement, NMP in which LiCl and phosphoric acid each were dissolved at a concentration of 0.05 mol/l was employed as the mobile phase and the running rate was set to 0.4 ml/minute.
Detector: Waters996
System controller: Waters2690
Column oven: Waters HTR-B
Thermo controller: Waters TCM
Column: TOSOH grard column
Column: TOSOH TSK-GEL α-4000
Column: TOSOH TSK-GEL α-2500.

### <Imidization ratio of polyimide synthesized>

First, the infrared absorption spectrum of a polymer was measured and the presence of absorption peaks (at about 1780 cm⁻¹ and about 1377 cm⁻¹) of the imide structure derived from polyimide was confirmed. Next, the polymer was subjected to a heat treatment for 1 hour at 350°C, after which the infrared absorption spectrum was measured again and the peak intensities at about 1377 cm⁻¹ before and after the heat treatment were compared. By assuming that the imidization ratio of the polymer after the heat treatment was 100%, an imidization ratio of the polymer before the heat treatment was determined.

### <Sticking property to substrate>

An adhesive composition prepared in each of Examples, Reference Examples and Comparative Examples was applied onto a PET film with a thickness of 38 µm using a comma roll coater and dried for 30 minutes at 100°C, after which as a protective film, a PP film with a thickness of 10 µm was laminated to obtain an adhesive sheet. Coating was carried out so that the adhesive sheet had a thickness of 120 µm. Afterward, the protective film was stripped off and the bare plane was laminated on a sheet of copper foil (NA-VLP with a thickness of 15 µm: available from MITSUI MINING & SMELTING CO., LTD) using a laminating machine (VTM-200M available from Takatori Corporation) under the conditions of a stage temperature of 130°C, a roll temperature of 130°C, a laminating speed of 2 mm/second, and an applied pressure of 0.4 MPa. Then, one in which an adhesive sheet does not remain on the support film and is stuck on copper foil when the support film is stripped off is defined as being good (O) and another one in which an adhesive sheet fails to be stuck and remains on the support film is defined as being poor (x).

### <Adhesive strength>

A protective film of an adhesive sheet obtained in the above-mentioned manner was stripped off and the bare plane was laminated on a sheet of copper foil using a laminating machine under the conditions of a stage temperature of 130°C, a roll temperature of 130°C, a laminating speed of 2 mm/second, and an applied pressure of 0.4 MPa. After the support film was stripped off, the adhesive sheet was placed on a hot plate at 180°C so that the copper foil faces downward and held there for 30 seconds. Afterward, another sheet of copper foil was laminated on the heated adhesive composition and subjected to thermocompression bonding for 1 minute under a pressure of 0.2 MPa. Following this, the composition was thermally cured over a 1-hour period in a hot air circulating dryer at 180°C. Copper foil on one side of the laminate thus obtained only was etched and removed with an aqueous ferric chloride solution and was subjected to fabrication for a circuit with a line width of 5 mm. Afterward, a strip of copper foil with a width of 5 mm was pulled upward in a direction at a 90 degree angle to the laminate with a push-pull gauge to measure the adhesive strength.

### < Thermal conductivity>

A protective film of an adhesive sheet obtained in the above-mentioned manner was stripped off and the bare plane was laminated on a sheet of copper foil using a laminating machine under the conditions of a stage temperature of 130°C, a roll temperature of 130°C, a laminating speed of 2 mm/second, and an applied pressure of 0.4 MPa. After the support film was stripped off, the adhesive sheet was thermally cured over 1 hour in a hot air circulating dryer at 180°C. The whole copper foil on the laminate thus obtained was etched and removed with an aqueous ferric chloride solution to obtain a cured product of the adhesive composition with a thickness of 120 µm. Afterward, the thermodiffusion coefficient of the cured product was measured using the laser flash thermal diffusivity measuring apparatus LFA447 available from NETZSCH Japan K.K. Moreover, the specific gravity of the cured product was measured by an Archimedes method and the specific heat of the cured product was measured by a DSC method to calculate the thermal conductivity according to the equation such that thermodiffusion coefficient x specific gravity x specific heat. The percentage content by volume of the filler was determined by dividing the weight of each of the ingredients of the resin composition added by the specific gravity to calculate the volume.

### <Withstand voltage>

A cured product of an adhesive composition was obtained in the same manner as above except for allowing the cured product of an adhesive composition to have a thickness of 200 µm. With regard to the product, the withstand voltage at a temperature of 23°C and a relative humidity of 50% RH was measured using the withstand voltage testing device TOS5101 available from KIKUSUI ELECTRONICS CORP. The measurement was carried out at a rate of voltage increase of 5.0 kV/second by an alternating current and a voltage measured at the time when an electric current of 0.2 mA or more flowed was defined as the withstand voltage.

The polyimide used in each of Examples, Reference Examples and Comparative Examples was synthesized according to the following method.

### Reference Example 1

In a 300-ml four-necked flask equipped with a stirrer, a thermometer, a nitrogen inlet tube and a dropping funnel, under a nitrogen atmosphere, were placed 105.68 g of γBL and 11.79 g of ODPA, the mixture being stirred at 60°C and dissolved. Then, to this, 29.71 g of Elastomer 1000, 2.98 g of SiDA and 1.47 g of BAHF were added at 60°C with stirring and stirred for 1 hour. Following this, the mixture was heated to 180°C and stirred for 2 hours, after which it was cooled to room temperature to obtain a polyimide solution A (solid content of 30.0% by weight). The weight-average molecular weight of the polyimide was determined to be 29,000 and the imidization ratio was determined to be 99%.

To 20.83 g of the polyimide solution A obtained in the above-mentioned manner, were added 12.5 g of EPICLON850S, 6.25 g of EXA-4850-150 and 0.8 g of 2PZ, the mixture being mixed and stirred. To this, were added 180 g of AO820 and 25 g of MBN-010T and a process in which the mixture is kneaded with a three roll mill was repeated 5 times to obtain an adhesive composition as a viscous liquid. The resulting adhesive composition was measured for the sticking property to copper foil, the adhesive strength, the thermal conductivity and the withstand voltage in the above-mentioned manner.

### Reference Example 2

In a 300-ml four-necked flask equipped with a stirrer, a thermometer, a nitrogen inlet tube and a dropping funnel, were placed 138.53 g of γBL and 14.74 g of ODPA under a nitrogen atmosphere, the mixture being stirred and dissolved at 60°C. Then, to this, 37.14 g of Elastomer 1000, 6.53 g of D-400 and 1.83 g of BAHF were added at 60°C with stirring and stirred for 1 hour. Following this, the mixture was heated to 180°C and stirred for 2 hours, after which it was cooled to room temperature to obtain a polyimide solution B (solid content of 30.0% by weight). The weight-average molecular weight of the polyimide was determined to be 26,800 and the imidization ratio was determined to be 98%. With 20.83 g of the polyimide solution B thus obtained, each of the ingredients was mixed in the same manner as in Reference Example 1 to obtain an adhesive composition. The resulting adhesive composition was evaluated for the sticking property to copper foil, the adhesive strength, the thermal conductivity and the withstand voltage in the above-mentioned manner.

### Reference Example 3

In a 300-ml four-necked flask equipped with a stirrer, a thermometer, a nitrogen inlet tube and a dropping funnel were placed 104.94 g of γBL and 11.79 g of ODPA under a nitrogen atmosphere, the mixture being stirred and dissolved at 60°C. Then, to this, 29.71 g of Elastomer 1000, 2.98 g of SiDA and 1.15 g of MBAA were added at 60°C with stirring and stirred for 1 hour. Following this, the mixture was heated to 180°C and stirred for 2 hours, after which it was cooled to room temperature to obtain a polyimide solution C (solid content of 30.0% by weight). The weight-average molecular weight of the polyimide was determined to be 30,500 and the imidization ratio was determined to be 99%. With 20.83 g of the polyimide solution C thus obtained, each of the ingredients was mixed in the same manner as in Reference Example 1 to obtain an adhesive composition. The resulting adhesive composition was evaluated for the sticking property to copper foil, the adhesive strength, the thermal conductivity and the withstand voltage in the above-mentioned manner.

### Reference Example 4

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 180 g of DAW-45 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 5

To 20.83 g of the polyimide solution A obtained in Example 1, were added 12.5 g of EPICLON850S, 6.25 g of EXA-4850-150 and 0.8 g of 2PZ, the mixture being mixed and stirred. To this, were added 180 g of AO509 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 6

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 180 g of AO502 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 7

To 20.83 g of the polyimide solution C obtained in Reference Example 3, were added 12.5 g of EPICLON850S, 6.25 g of EXA-4850-150 and 0.8 g of 2PZ, the mixture being mixed and stirred. To this, were added 180 g of AO509 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 8

To 20.83 g of the polyimide solution C obtained in Reference Example 3, were added 12.5 g of EPICLON850S, 6.25 g of EXA-4850-150 and 0.8 g of 2PZ, the mixture being mixed and stirred. To this, were added 180 g of AO509, 33 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 9

To 20.83 g of the polyimide solution C obtained in Reference Example 3, were added 12.5 g of EPICLON850S, 6.25 g of EXA-4850-150 and 0.8 g of 2PZ, the mixture being mixed and stirred. To this, were added 180 g of AO509, 66 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 10

In a 300-ml four-necked flask equipped with a stirrer, a thermometer, a nitrogen inlet tube and a dropping funnel were placed 127.61 g of γBL and 13.18 g of ODPA under a nitrogen atmosphere, the mixture being stirred and dissolved at 60°C. Then, to this, 37.14 g of Elastomer 1000, 3.73 g of SiDA and 1.43 g of MBAA were added at 60°C with stirring and stirred for 1 hour. Following this, the mixture was heated to 180°C and stirred for 2 hours, after which it was cooled to room temperature to obtain a polyimide solution D (solid content of 30.0% by weight). The weight-average molecular weight of the polyimide was determined to be 12,000 and the imidization ratio was determined to be 99%. With 20.83 g of the polyimide solution D thus obtained, each of the ingredients was mixed in the same manner as in Example 9 to obtain an adhesive composition. The resulting adhesive composition was evaluated for the sticking property to copper foil, the adhesive strength, the thermal conductivity and the withstand voltage in the above-mentioned manner.

### Example 11

To 20.83 g of the polyimide solution D obtained in Example 10, were added 12.5 g of EPICLON850S, 6.25 g of NC3000 and 0.8 g of 2PZ, the mixture being mixed and stirred. To this, were added 180 g of AO509, 66 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 12

To 20.83 g of the polyimide solution D obtained in Example 10, were added 6.25 g of EPICLON850S, 9.25 g of NC3000, 3.25 g of PG100 and 0.8 g of 2PZ, the mixture being mixed and stirred. To this, were added 180 g of AO509, 66 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 13

To 20.83 g of the polyimide solution D obtained in Example 10, were added 6.25 g of EPICLON850S, 9.25 g of NC3000, 3.25 g of PG100 and 0.8 g of 2PZ, the mixture being mixed and stirred. To this, were added 180 g of AO509, 99 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 14

To 20.83 g of the polyimide solution D obtained in Example 10, were added 6.25 g of EPICLON850S, 9.25 g of NC3000, 3.25 g of PG100 and 0.8 g of 2PZ, the mixture being mixed and stirred. To this, were added 180 g of AO509, 66 g of FAN-50 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 15

To 20.83 g of the polyimide solution D obtained in Example 10, were added 6.25 g of EPICLON850S, 9.25 g of NC3000, 3.25 g of PG100 and 0.8 g of 2PZ, the mixture being mixed and stirred. To this, were added 180 g of AO509, 99 g of FAN-50 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 16

To 20.83 g of the polyimide solution A obtained in Reference Example 1, were added 6.25 g of EPICLON850S, 9.25 g of NC3000, 3.25 g of PG100 and 0.8 g of 2PZ, the mixture being mixed and stirred. To this, were added 180 g of AO509, 66 g of FAN-50 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 17

In a 300-ml four-necked flask equipped with a stirrer, a thermometer, a nitrogen inlet tube and a dropping funnel were placed 128.53 g of γBL and 13.18 g of ODPA under a nitrogen atmosphere, the mixture being stirred and dissolved at 60°C. Then, to this, 37.14 g of Elastomer 1000, 3.73 g of SiDA and 1.83 g of BAHF were added at 60°C with stirring and stirred for 1 hour. Following this, the mixture was heated to 180°C and stirred for 2 hours, after which it was cooled to room temperature to obtain a polyimide solution E (solid content of 30.0% by weight). The weight-average molecular weight of the polyimide was determined to be 13,000 and the imidization ratio was determined to be 99%. With 20.83 g of the polyimide solution E thus obtained, each of the ingredients was mixed in the same manner as in Example 14 to obtain an adhesive composition. The resulting adhesive composition was evaluated for the sticking property to copper foil, the adhesive strength, the thermal conductivity and the withstand voltage in the above-mentioned manner.

### Example 18

To 41.7 g of the polyimide solution D obtained in Example 10, were added 9.25 g of NC3000, 3.25 g of PG100 and 0.8 g of 2PZ, the mixture being mixed and stirred. To this, were added 180 g of AO509, 66 g of FAN-50 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 19

To 55.0 g of the polyimide solution D obtained in Example 10, were added 6.25 g of NC3000, 2.25 g of PG100 and 0.8 g of 2PZ, the mixture being mixed and stirred. To this, were added 180 g of AO509, 66 g of FAN-50 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 20

To 20.83 g of the polyimide solution D obtained in Example 10, were added 6.25 g of EPICLON850S, 9.25 g of NC3000, 3.25 g of PG100 and 0.8 g of 2PZ, the mixture being mixed and stirred. To this, were added 260 g of AO509 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 21

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 180 g of AO820, 33 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 22

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 120 g of AO820, 33 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 23

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 120 g of AO820, 33 g of FAN-05 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 24

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 140 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Reference Example 25

In a 300-ml four-necked flask equipped with a stirrer, a thermometer, a nitrogen inlet tube and a dropping funnel, under a nitrogen atmosphere, were placed 104.00 g of γBL and 20.63 g of ODPA, the mixture being stirred at 60°C and dissolved. Then, to this, 8.67 g of Elastomer 1000, 13.92 g of SiDA and 2.56 g of BAHF were added at 60°C with stirring and stirred for 1 hour. Following this, the mixture was heated to 180°C and stirred for 2 hours, after which it was cooled to room temperature to obtain a polyimide solution F (solid content of 30.0% by weight). The weight-average molecular weight of the polyimide was determined to be 31,400 and the imidization ratio was determined to be 98%. With 20.83 g of the polyimide solution F thus obtained, each of the ingredients was mixed in the same manner as in Reference Example 1 to obtain an adhesive composition. The resulting adhesive composition was evaluated for the sticking property to copper foil, the adhesive strength, the thermal conductivity and the withstand voltage in the above-mentioned manner.

### Reference Example 26

To 20.83 g of the polyimide solution B obtained in Reference Example 2, were added 12.5 g of EPICLON850S, 6.25 g of EXA-4850-150 and 0.8 g of 2PZ, the mixture being mixed and stirred. To this, were added 180 g of AO820, 33 g of FAN-30 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Example 27

The adhesive composition obtained in Reference Example 1 was applied on a sheet of copper foil using a bar coater and dried for 30 minutes in a hot air dryer at 100°C. In this way, a laminate prepared by allowing an adhesive composition with a thickness of 120 µm to be stacked on the sheet of copper foil was obtained. The laminate was placed on a hot plate at 130°C so that the copper foil faces downward. Another sheet of copper foil was superimposed on the adhesive composition and pressed for 5 minutes under a pressure of 0.4 MPa. Afterward, the laminate was thermally cured for 60 minutes at 180°C. The laminate thus obtained was evaluated for the adhesive strength and the thermal conductivity in the above-mentioned manner. Similar results to those of Reference Example 1 were obtained, for the adhesive strength to copper foil was determined to be 8.2 N/cm and the thermal conductivity was determined to be 6.6 W/mK. Moreover, the withstand voltage of a laminate prepared by allowing an adhesive composition with a thickness of 200 µm to be stacked on a sheet of copper foil in the same manner as above was measured. A similar result to that of Reference Example 1 was obtained, for the withstand voltage was determined to be 2.3 kV.

### Examples 28 to 39

With regard to the adhesive compositions obtained in Examples 8 to 19, the same procedure as in Example 27 was performed and the compositions were evaluated for the adhesive strength, the thermal conductivity and the withstand voltage. In each of Examples 28 to 39, similar results to those of each of Examples 8 to 19 were obtained.

### Comparative Example 1

In a 300-ml four-necked flask equipped with a stirrer, a thermometer, a nitrogen inlet tube and a dropping funnel were placed 106.45 g of γBL and 23.58 g of ODPA under a nitrogen atmosphere, the mixture being stirred and dissolved at 60°C. Then, to this, 13.92 g of SiDA and 8.79 g of BAHF were added at 60°C with stirring and stirred for 1 hour. Following this, the mixture was heated to 180°C and stirred for 2 hours, after which it was cooled to room temperature to obtain a polyimide solution G (solid content of 30.0% by weight). The weight-average molecular weight of the polyimide was determined to be 26,700 and the imidization ratio was determined to be 99%. With 20.83 g of the polyimide solution G thus obtained, each of the ingredients was mixed in the same manner as in Reference Example 1 to obtain an adhesive composition. Although the resulting adhesive composition was evaluated for the sticking property to copper foil, the adhesive strength and the thermal conductivity in the above-mentioned manner, the composition failed to be stuck on copper foil. Accordingly, the adhesive composition was stripped from the supporting substrate and thermally cured on a "Teflon" (registered trademark) petri dish to measure the thermal conductivity and the withstand voltage.

### Comparative Example 2

To 83.3 g of the polyimide solution A obtained in Reference Example 1, were added 180 g of AO820 and 25 g of MBN-010T and a process in which the mixture is kneaded with a three roll mill was repeated 5 times to obtain an adhesive composition as a viscous liquid. Although the resulting adhesive composition was evaluated for the sticking property to copper foil, the adhesive strength and the thermal conductivity in the above-mentioned manner, the composition failed to be stuck on copper foil. Accordingly, the adhesive composition was stripped from the supporting substrate and thermally cured on a "Teflon" (registered trademark) petri dish to measure the thermal conductivity and the withstand voltage.

### Comparative Example 3

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, was added 83 g of AO502 and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner.

### Comparative Example 4

To 20.83 g of the polyimide solution A obtained in Reference Example 1, were added 12.5 g of EPICLON850S, 6.25 g of EXA-4850-150 and 0.8 g of 2PZ, the mixture being mixed and stirred. To this, were added 35 g of HP-40 and 25 g of MBN-010T and a process in which the mixture is kneaded with a three roll mill was repeated 5 times to obtain an adhesive composition as a viscous liquid. The resulting adhesive composition was evaluated for the sticking property to copper foil, the adhesive strength, the thermal conductivity and the withstand voltage in the above-mentioned manner. However, the dispersibility of the thermally conductive filler was poor and an adhesive sheet with a surface in good condition was not obtained.

The specifications given for its composition and the evaluation results of the adhesive composition obtained in each of Examples, Reference Examples and Comparative Examples are shown in Tables 1 to 4 and Tables 5 to 7, respectively.

Because of the contrast between each Example, Reference Example and Comparative Example, it has been found that using the adhesive composition or the adhesive sheet which contains an organic-solvent-soluble polyimide (A), an epoxy resin (B) and a thermally conductive filler (C), allowing the polyimide (A) to contain a structure represented by general formula (1) as a component derived from a diamine and allowing the content of the thermally conductive filler (C) in the whole resin composition to be not less than 60% by volume gives excellent results for all of the sticking property to copper foil, the adhesive strength and the thermal conductivity.

Moreover, because of the contrast between Reference Example 5 and Reference Example 6, it has been found that allowing a thermally conductive filler with an average particle diameter of 6 µm or more to be present in the adhesive composition or the adhesive sheet is preferred in the point that the adhesive strength and the thermal conductivity are further enhanced.

Moreover, in comparison between Reference Example 22 and Reference Example 23, it has been found that allowing the content of a thermally conductive filler with an average particle diameter of 6 µm or more in the adhesive composition or the adhesive sheet to be not less than 50% by volume is preferred in the point that the thermal conductivity is further enhanced.

Moreover, in comparison between Reference Example 1 and Reference Example 24, it has been found that allowing such a thermally conductive filler that the pH of the liquid prepared when 10 g of the thermally conductive filler is added to 100 g of water is not more than 6.0 to be present in the adhesive composition or the adhesive sheet as the thermally conductive filler (C) is preferred in the point that the adhesive strength and the thermal conductivity are further enhanced.

Moreover, in comparison between Reference Example 1 and Reference Example 2 and the contrast between Reference Example 21 and Reference Example 26, it has been found that allowing the organic-solvent-soluble polyimide (A) to have a residue of a diamine represented by general formula (2) in the adhesive composition or the adhesive sheet is preferred in the point that the adhesive strength is further enhanced.

Moreover, in comparison between Reference Example 1 and Reference Example 25, it has been found that allowing the organic-solvent-soluble polyimide (A) in the adhesive composition or the adhesive sheet to have a diamine residue with a structure represented by general formula (1) in 20% by mole or more content relative to all the diamine residues is preferred in the point that the adhesive strength is further enhanced.

Moreover, in comparison between Reference Examples 7 and 20 and Examples 8 to 13, it has been found that allowing a filler with an average particle diameter of 6 µm or more and 15 µm or less and a filler with an average particle diameter of 30 µm or more, more preferably 40 µm or more, to be present in the adhesive composition or the adhesive sheet is preferred in the point that the thermal conductivity is further enhanced.

**[Table 1]**

| Items | | | Average particle diameter (µm) | pH | Example 1 | Example 2 | Example 3 | Example 4 | Example 5 | Example 6 | Example 7 | Example 8 | Example 9 |
|---|---|---|---|---|---|---|---|---|---|---|---|---|---|
| | Tetracarboxylic acid dianhydride | ODPA | | | 95 | 95 | 95 | 95 | 95 | 95 | 95 | 95 | 95 |
| Polyimide compositio n (mole ratio) | Diamine represented by formula (1) | D400 | | | | 30 | - | - | - | - | - | - | - |
| | | Elastomer 1000 | | | 60 | 60 | 60 | 60 | 60 | 60 | 60 | 60 | 60 |
| | Diamine represented by formula (2) | SiDA | | | 30 | - | 30 | 30 | 30 | 30 | 30 | 30 | 30 |
| | Other diamines | MBAA | | | | - | 10 | - | - | - | 10 | 10 | 10 |
| | | BAHF | | | 10 | 10 | - | 10 | 10 | 10 | - | - | - |
| Polyimide Imidization ratio (%) | | | | | 99 | 98 | 99 | 99 | 99 | 99 | 99 | 99 | 99 |
| Polyimide weight-average molecular weight | | | | | 29000 | 26800 | 30500 | 29000 | 29000 | 29000 | 30500 | 30500 | 30500 |
| | (A) polyimide | | | | 6,25 | 6,25 | 6,25 | 6,25 | 6,25 | 6,25 | 6,25 | 6,25 | 6,25 |
| | Epoxy resin | EPICLON850S | | | 12,5 | 12,5 | 12,5 | 12,5 | 12,5 | 12,5 | 12,5 | 12,5 | 12,5 |
| | | EXA-4850-150 | | | 6,25 | 6,25 | 6,25 | 6,25 | 6,25 | 6,25 | 6,25 | 6,25 | 6,25 |
| | | NC3000 | | | | - | - | - | - | - | - | - | - |
| | | PG100 | | | | - | - | - | - | - | - | - | - |
| | Hardening accelerator | 2PZ | | | 0,8 | 0,8 | 0,8 | 0,8 | 0,8 | 0,8 | 0,8 | 0,8 | 0,8 |
| | Thermally conductive filler | DAW-45 | 45 | 5,7 | - | - | - | 180 | - | - | - | - | - |
| | | AO820 | 20 | 5,2 | 180 | 180 | 180 | - | - | - | - | - | - |
| | | AO509 | 9 | 5,4 | - | - | - | - | 180 | - | 180 | 180 | 180 |
| | | AO502 | 0,7 | 5,5 | - | | - | - - | - | 180 | - | - | - |
| | | FAN-50 | 50 | 10,5 | - | - | - | - | - | - | - | - | - |
| | | FAN-30 | 30 | 10,5 | - | - | - | - | - | - | - | 33 | 66 |
| Adhesive resin compositio n (parts by weight) | | FAN-05 | 5 | 10,2 | | | | | - | - | - | - | - |
| | | HP-40 | 8 | 6,8 | - | - | - | - | - | - | - | - | - |
| | | MBN-010T | 0,9 | 7,5 | 25 | 25 | 25 | 25 | 25 | 25 | 25 | 25 | 25 |
| | Amount of thermally conductive filler with an average particle diameter of 6 mm or more added (vol.%) | | | | 58 | 58 | 58 | 58 | 58 | 0 | 58 | 63 | 67 |
| | Amount of thermally conductive filler with an average particle diameter of 6 to 15 mm added (vol.%) | | | | 0 | 0 | 0 | 0 | 58 | 0 | 58 | 51 | 46 |
| | Amount of thermally conductive filler with an average particle diameter of 30 mm or more added (vol.%) | | | | 0 | 0 | 0 | 58 | 0 | 0 | 0 | 12 | 21 |
| | Amount of thermally conductive filler added (vol.%) | | | | 73 | 73 | 73 | 73 | 73 | 73 | 73 | 76 | 79 |

In Table 1 Examples 1 to 7 are Reference Examples not belonging to the present invention.

**[Table 2]**

| Items | | | Average particle diameter (µm) | ph | Example 10 | Example 11 | Example 12 | Example 13 | Example 14 | Example 15 | Example 16 | Example 17 | Example 18 | Example 19 | Example 20 |
|---|---|---|---|---|---|---|---|---|---|---|---|---|---|---|---|
| | Tetracarboxylic acid dianhydride | ODPA | | | 85 | 85 | 85 | 85 | 85 | 85 | 95 | 85 | 85 | 85 | 85 |
| Polyimide compositio n (mole ratio) | Diamine represented by formula (1) | D400 | | | - | - | - | - | - | - | - | - | - | - | - |
| | | Elastomer 1000 | | | 60 | 60 | 60 | 60 | 60 | 60 | 60 | 60 | 60 | 60 | 60 |
| | Diamine represented by formula (2) | SiDA | | | 30 | 30 | 30 | 30 | 30 | 30 | 30 | 30 | 30 | 30 | 30 |
| | Other diamines | MBAA | | | 10 | 10 | 10 | 10 | 10 | 10 | - | - | 10 | 10 | 10 |
| | | BAHF | | | - | - | - | - | - | - | 10 | 10 | - | - | - |
| Polyimide Imidization ratio (%) | | | | | 99 | 99 | 99 | 99 | 99 | 99 | 99 | 99 | 99 | 99 | 99 |
| Polyimide weight-average molecular weight | | | | | 12000 | 12000 | 12000 | 12000 | 12000 | 12000 | 29000 | 13000 | 12000 | 12000 | 12000 |
| | (A) polyimide | | | | 6,25 | 6,25 | 6,25 | 6,25 | 6,25 | 6,25 | 6,25 | 6,25 | 12,5 | 16,5 | 6,25 |
| | Epoxy resin | EPICLON850S | | | 12,5 | 12,5 | 6,25 | 6,25 | 6,25 | 6,25 | 6,25 | 6,25 | - | - | 6,25 |
| | | EXA-4850-150 | | | 6,25 | - | | - | - | - | - | - | - | - | - |
| | | NC3000 | | | - | 6,25 | 9,25 | 9,25 | 9,25 | 9,25 | 9,25 | 9,25 | 9,25 | 6,25 | 9,25 |
| | | PG100 | | | - | - | 3,25 | 3,25 | 3,25 | 3,25 | 3,25 | 3,25 | 3,25 | 2,25 | 3,25 |
| | Hardening accelerator | 2PZ | | | 0,8 | 0,8 | 0,8 | 0,8 | 0,8 | 0,8 | 0,8 | 0,8 | 0,8 | 0,8 | 0,8 |
| | Thermally conductive filler | DAW-45 | 95 | 5,7 | - | - | - | - | - | - | - | - | - | - | - |
| | | AO820 | 20 | 5,2 | - | - | - | - | - | - | - | - | - | - | - |
| | | AO509 | 9 | 5,4 | 180 | 180 | 180 | 180 | 180 | 180 | 180 | 180 | 180 | 180 | 260 |
| | | AO502 | 0,7 | 5,5 | - | - | - | - | - | - | - | - | - | - | - |
| Adhesive resin compositio n (parts by weight) | | FAN-50 | 50 | 10,5 | - | - | - | - | 66 | 99 | 66 | 66 | 66 | 66 | - |
| | | FAN-30 | 30 | 10,5 | 66 | 66 | 66 | 99 | - | - | - | - | - | - | - |
| | | FAN-05 | 5 | 10,2 | - | - | - | - | - | - | - | - | - | - | - |
| | | HP-40 | 8 | 6,8 | - | - | - | - | - | - | - | - | - | - | - |
| | | MBN-010T | 0,9 | 7,5 | 25 | 25 | 25 | 25 | 25 | 25 | 25 | 25 | 25 | 25 | 25 |
| | Amount of thermally conductive filler with an average particle diameter of 6 mm or more added (vol.%) | | | | 67 | 67 | 67 | 70 | 67 | 70 | 67 | 67 | 67 | 67 | 67 |
| | Amount of thermally conductive filler with an average particle of 6 to 15 mm added (vol.%) | | | | 46 | 96 | 96 | 42 | 96 | 42 | 96 | 96 | 96 | 96 | 67 |
| | Amount of thermally conductive filler with an average particle diameter of 30 mm or more added (vol.%) | | | | 21 | 21 | 21 | 28 | 21 | 28 | 21 | 21 | 21 | 21 | 0 |
| | Amount of thermally conductive filler added (vol.%) | | | | 79 | 79 | 79 | 81 | 79 | 81 | 79 | 79 | 79 | 79 | 79 |

In Table 2 Example 20 is a Reference Example not belonging to the present invention.

**[Table 3]**

| Items | | | Average particle diameter (µm) | ph | Example 21 | Example 22 | Example 23 | Example 24 | Example 25 | Example 26 |
|---|---|---|---|---|---|---|---|---|---|---|
| | Tetracarboxylic acid dianhydride | ODPA | | | 95 | 95 | 95 | 95 | 95 | 95 |
| Polyimide compositio n (mole ratio) | Diamine represented by formula (1) | D400 | | | - | - | - | - | - | 30 |
| | | Elastomer 1000 | | | 60 | 60 | 60 | 60 | 10 | 60 |
| | Diamine represented by formula (2) | SiDA | | | 30 | 30 | 30 | 30 | 80 | - |
| | Other diamines | MBAA | | | - | - | - | - | - | - |
| | | BAHF | | | 10 | 10 | 10 | 10 | 10 | 10 |
| Polyimide Imidization ratio (%) | | | | | 99 | 99 | 99 | 99 | 98 | 98 |
| Polyimide weight-average molecular weight | | | | | 29000 | 29000 | 29000 | 29000 | 31400 | 26800 |
| | (A) polyimide | | | | 6,25 | 6,25 | 6,25 | 6,25 | 6,25 | 6,25 |
| | Epoxy resin | EPICLON850S | | | 12,5 | 12,5 | 12,5 | 12,5 | 12,5 | 12,5 |
| | | EXA-4850-150 | | | 6,25 | 6,25 | 6,25 | 6,25 | 6,25 | 6,25 |
| | | NC3000 | | | - | - | - | - | - | - |
| | | PG100 | | | - | - | - | - | - | - |
| | Hardening accelerator | 2PZ | | | 0,8 | 0,8 | 0,8 | 0,8 | 0,8 | 0,8 |
| | Thermally conductive filler | DAW-45 | 45 | 5,7 | - | - | - | - | - | - |
| | | AO820 | 20 | 5,2 | 180 | 120 | 120 | - | 180 | 180 |
| | | AO509 | 9 | 5,4 | - | - | - | - | - | - |
| | | AO502 | 0,7 | 5,5 | - | - | - | - | - | - |
| Adhesive resin compositio n (parts by weight) | | FAN-50 | 50 | 10,5 | - | - | - | - | - | - |
| | | FAN-30 | 30 | 10,5 | 33 | 33 | - | 140 | - | 33 |
| | | FAN-05 | 5 | 10,2 | - | - | 33 | - | - | - |
| | | HP-40 | 8 | 6,8 | - | - | - | - | - | - |
| | | MBN-010T | 0,9 | 7,5 | 25 | 25 | 25 | 25 | 25 | 25 |
| | Amount of thermally conductive filler with an average particle diameter of 6 mm or more added (vol.%) | | | | 63 | 55 | 42 | 58 | 58 | 63 |
| | Amount of thermally conductive filler with an average particle diameter of 6 to 15 mm added (vol. o) | | | | 0 | 0 | 0 | 0 | 0 | 0 |
| | Amount of thermally conductive filler with an average particle diameter of 30 mm or more added (vol.%) | | | | 12 | 14 | 0 | 57 | 0 | 12 |
| | Amount of thermally conductive filler added (vol.%) | | | | 76 | 71 | 71 | 72 | 73 | 76 |

In Table 3 Examples 21 to 26 are Reference Examples not belonging to the present invention.

**[Table 4]**

| Items | | | Average particle diameter (µm) | pH | Comparative Example 1 | Comparative Example 2 | Comparative Example 3 | Comparative Example 4 |
|---|---|---|---|---|---|---|---|---|
| | Tetracarboxylic acid dianhydride | ODPA | | | 95 | 95 | 95 | 95 |
| Polyimide compositio n (mole ratio) | Diamine represented by formula (1) | D400 | | | - | - | | |
| | | Elastomer 1000 | | | - | 60 | 60 | 60 |
| | Diamine represented by formula (2) | SiDA | | | 70 | 30 | 30 | 30 |
| | Other diamines | MBAA | | | - | - | - | |
| | | BAHF | | | 30 | 10 | 10 | 10 |
| Polyimide Imidization ratio (%) | | | | | 99 | 99 | 99 | 99 |
| Polyimide weight-average molecular weight | | | | | 26700 | 29000 | 29000 | 29000 |
| | (A) polyimide | | | | 6,25 | 25 | 6, 25 | 6, 25 |
| | (B) epoxy resin | EPICLON850S | | | 12,5 | - | 12,5 | 12,5 |
| | | EXA-4850-150 | | | 6, 25 | - | 6, 25 | 6, 25 |
| | Hardening accelerator | 2PZ | | | 0,8 | - | 0,8 | 0,8 |
| | | DAW-45 | 45 | 5,7 | - | - | - | - |
| | | AO820 | 20 | 5,2 | 180 | 180 | - | - |
| Adhesive resin compositio n (parts by weight) | | AO509 | 9 | 5,4 | - | - | - | - |
| | (C) thermally conductive filler | AO502 | 0,7 | 5,5 | - | - | 83 | |
| | | FAN-30 | 30 | 10,5 | - | - | - | - |
| | | FAN-05 | 5 | 10,2 | - | - | - | - |
| | | HP-40 | 8 | 6,8 | - | - | - | 35 |
| | | MBN-010T | 0,9 | 7,5 | 25 | 25 | - | 25 |
| | Amount of thermally conductive filler with an average particle diameter of 6 mm or more added (vol.%) | | | | 58 | 58 | 0 | 33 |
| | Amount of thermally conductive filler added (vol.%) | | | | 73 | 73 | 50 | 56 |

**[Table 5]**

| Items | Example 1 | Example 2 | Example 3 | Example 4 | Example 5 | Example 6 | Example 7 | Example 8 | Example 9 | Example 10 |
|---|---|---|---|---|---|---|---|---|---|---|
| Sticking property | ○ | ○ | ○ | ○ | ○ | ○ | ○ | ○ | ○ | ○ |
| Adhesive strength (N/cm) | 8.5 | 7.7 | 8.2 | 6.5 | 8.6 | 5.7 | 8.8 | 8.6 | 8.2 | 8.9 |
| Thermal Conductivity (W/mK) | 6.6 | 6.3 | 6.4 | 7.8 | 4.4 | 2.2 | 4.6 | 7.2 | 8.2 | 9.2 |
| Withstand voltage (kV) | 2.6 | 2.4 | 1.9 | 2.8 | 4.7 | 1.1 | 4.8 | 4.1 | 3.5 | 4.6 |

In Table 5 Examples 1 to 7 are Reference Examples not belonging to the present invention.

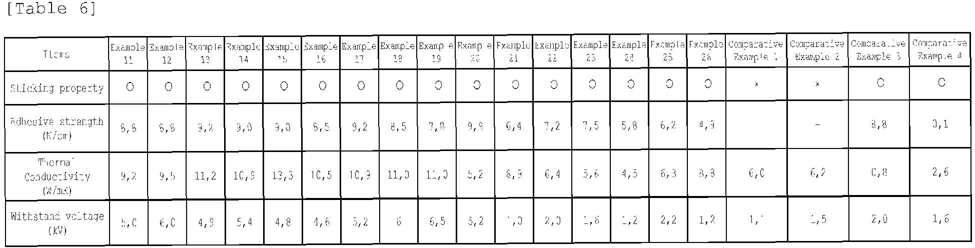

In Table 6 Examples 20 to 26 are Reference Examples not belonging to the present invention.

**[Table 7]**

| Items | Example 27 | Example 28 | Example 29 | Example 30 | Example 31 | Example 32 | Example 33 | Example 34 | Example 35 | Example 36 | Example 37 | Example 38 | Example 39 |
|---|---|---|---|---|---|---|---|---|---|---|---|---|---|
| Sticking property | ○ | ○ | ○ | ○ | ○ | ○ | ○ | ○ | ○ | ○ | ○ | ○ | ○ |
| Adhesive strength (N/cm) | 8.2 | 8.5 | 8.2 | 8.9 | 9.0 | 8.6 | 9.0 | 9.0 | 9.2 | 8.8 | 9.0 | 8.8 | 7.8 |
| Thermal Conductivity (W/mK) | 6.6 | 7.4 | 8.4 | 9 | 9.0 | 9.8 | 11.2 | 10.6 | 13.2 | 10.5 | 10.9 | 10.8 | 11.0 |
| Withstand voltage (kV) | 2.3 | 4.1 | 3.6 | 4.6 | 5.0 | 6.5 | 5.2 | 5.4 | 4.8 | 4.9 | 5.0 | 6.0 | 6.8 |

## Claims

1. An adhesive composition containing an organic-solvent-soluble polyimide (A), an epoxy resin (B) and a thermally conductive filler (C), an organic-solvent-soluble polyimide (A) containing a structure represented by the following general formula (1) as a component derived from a diamine, and the content of a thermally conductive filler (C) in the adhesive composition being not less than 60% by volume,
the thermally conductive filler(C) includes two or more fillers differing in the average particle diameter and contains at least a filler with an average particle diameter of 6 µm or more and 15 µm or less and a filler with an average particle diameter of 30 µm or more, the content of the thermally conductive filler with an average particle diameter of 30 µm or more is not less than 10% by volume and not more than 35% by volume, and the average particle diameter is measured by a method of directly observing the particles with a SEM (scanning electron microscope) or a TEM (transmission electron microscope) and calculating a number average of particle diameter 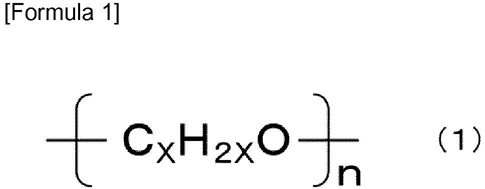 wherein in general formula (1), X represents an integer of 1 to 10 inclusive and n represents an integer of 1 to 20 inclusive.

2. The adhesive composition according to claim 1, wherein the thermally conductive filler (C) includes a filler that the pH of the liquid prepared when 10 g of the thermally conductive filler is added to 100 g of water is not more than 6.0.

3. The adhesive composition according to claim 1 or 2, wherein the thermally conductive filler (C) includes alumina.

4. The adhesive composition according to any one of claims 1 to 3, wherein the organic-solvent-soluble polyimide (A) has a residue of a diamine represented by the following general formula (2): 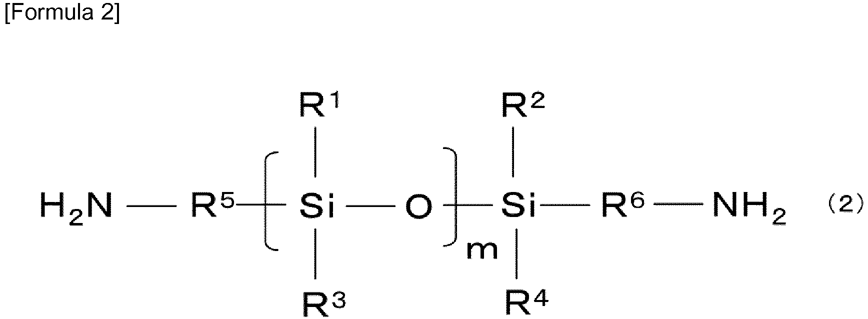 wherein in the general formula (2), m represents a range of 1 to 30. Moreover, R⁵ and R⁶ may be the same or different and represent an alkylene group with 1 to 30 carbon atoms or a phenylene group. R¹ to R⁴ each may be the same or different and represent an alkyl group with 1 to 30 carbon atoms, a phenyl group or a phenoxy group.

5. An adhesive sheet containing an organic-solvent-soluble polyimide (A), an epoxy resin (B) and a thermally conductive filler (C), an organic-solvent-soluble polyimide (A) containing a structure represented by the following general formula (1) as a component derived from a diamine, the content of a thermally conductive filler (C) in the sheet being not less than 60% by volume, the thermally conductive filler (C) includes two or more fillers differing in the average particle diameter and contains at least a filler with an average particle diameter of 6 µm or more and 15 µm or less and a filler with an average particle diameter of 30 µm or more, he content of the thermally conductive filler with an average particle diameter of 30 µm or more is not less than 10% by volume and not more than 35% by volume, and the average particle diameter is measured by a method of directly observing the particles with a SEM (scanning electron microscope) or a TEM (transmission electron microscope) and calculating a number average of particle diameter 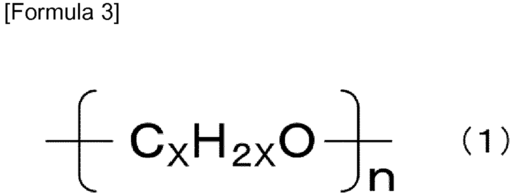 wherein in general formula (1), X represents an integer of 1 to 10 inclusive and n represents an integer of 1 to 20 inclusive.

6. The adhesive sheet according to claim 5, wherein the thermally conductive filler (C) includes a filler that the pH measured when 10 g of the thermally conductive filler is added to 100 g of water is not more than 6.0.

7. The adhesive sheet according to claim 5 or 6, wherein the thermally conductive filler (C) includes alumina.

8. The adhesive sheet according to any one of claims 5 to 7, wherein the organic-solvent-soluble polyimide (A) has a residue of a diamine represented by the following general formula (2): 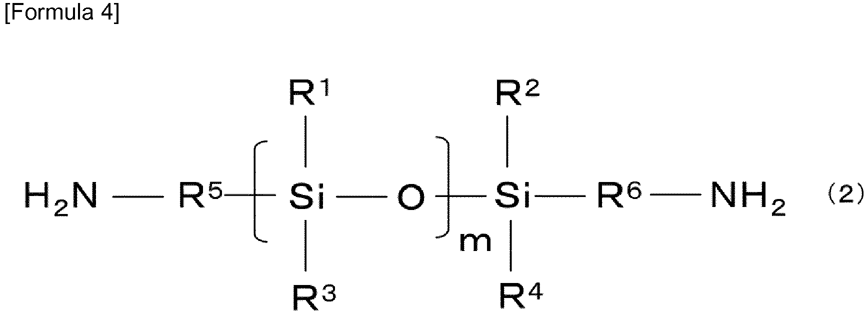 wherein in the general formula (2), m represents a range of 1 to 30. Moreover, R⁵ and R⁶ may be the same or different and represent an alkylene group with 1 to 30 carbon atoms or a phenylene group. R¹ to R⁴ each may be the same or different and represent an alkyl group with 1 to 30 carbon atoms, a phenyl group or a phenoxy group.

9. A cured product of an adhesive composition according to any one of claims 1 to 4 or of an adhesive sheet according to any one of claims 5 to 8.

10. A semiconductor device comprising a cured product of an adhesive composition according to any one of claims 1 to 4 or of an adhesive sheet according to any one of claims 5 to 8.

## Patentansprüche

1. Klebstoffzusammensetzung umfassend ein in einem organischen Lösemittel lösliches Polyimid (A), ein Epoxidharz (B) und einen thermisch leitenden Füllstoff (C), wobei das in einem organischen Lösemittel lösliche Polyimid (A) eine Struktur, welche durch die folgende allgemeine Formel (1) als eine Komponente, die von einem Diamin abgeleitet ist, dargestellt ist, umfasst, und der Anteil des thermisch leitfähigen Füllstoffes (C) in der Klebstoffzusammensetzung nicht mehr als 60 Vol.-% beträgt, wobei der thermisch leitfähige Füllstoff (C) zwei oder mehr Füllstoffe enthält, die sich im durchschnittlichen Partikeldurchmesser unterscheiden und mindestens einen Füllstoff mit einem durchschnittlichen Partikeldurchmesser von 6 µm oder mehr und 15 µm oder weniger und einen thermisch leitfähigen Füllstoff mit einem durchschnittlichen Partikeldurchmesser von 30 µm oder mehr umfasst, wobei der Anteil des thermisch leitfähigen Füllstoffes mit einem Durchmesser von 30 µm oder mehr nicht weniger als 10 Vol.-% und nicht mehr als 35 Vol.-% beträgt, und der durchschnittliche Partikeldurchmesser direkt mittels einer Methode des direkten Beobachtens der Partikel mit einem REM (Rasterelektronenmikroskop) oder einem TEM (Transmissionselektronenmikroskop) gemessen und eine Durchschnittszahl der Partikeldurchmesser berechnet wird 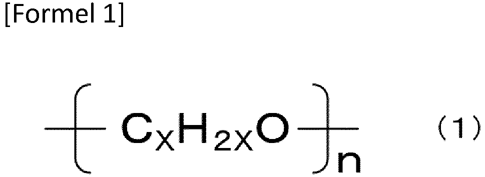 wobei in der allgemeinen Formel (1) X eine Ganzzahl von 1 bis einschließlich 10 darstellt und n eine Ganzzahl von 1 bis einschließlich 20 darstellt.

2. Klebstoffzusammensetzung nach Anspruch 1, wobei der thermisch leitfähige Füllstoff (C) einen Füllstoff enthält, damit der pH-Wert der hergestellten Flüssigkeit, wenn 10 g des thermisch leitfähigen Füllstoffes zu 100 g Wasser hinzugeben werden, nicht mehr als 6,0 ist.

3. Klebstoffzusammensetzung nach Anspruch 1 oder 2, wobei der thermisch leitfähige Füllstoff (C) Aluminiumoxid beinhaltet.

4. Klebstoffzusammensetzung nach einem der Ansprüche 1 bis 3, wobei das in einem organischen Lösemittel lösliche Polyimid (A) einen Rest eines Diamins, welches durch die folgende allgemeine Formel (2) dargestellt ist, umfasst: 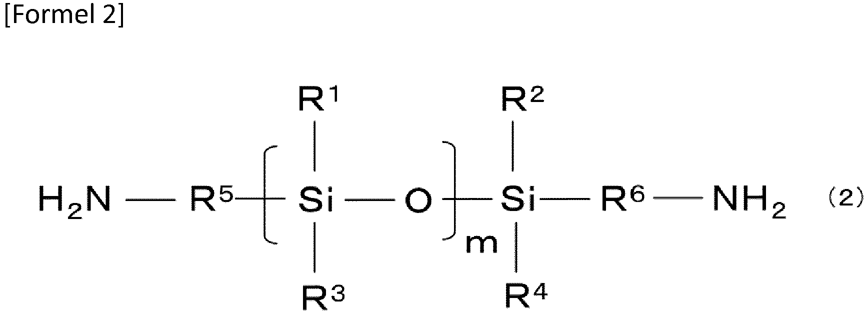 wobei in der allgemeinen Formel (2) m einen Bereich von 1 bis 30 darstellt. Darüber hinaus können R⁵ und R⁶ gleich oder unterschiedlich sein und eine Alkylengruppe mit 1 bis 30 Kohlenstoffatomen oder eine Phenylengruppe darstellen. R¹ bis R⁴ können jeweils gleich oder unterschiedlich sein und eine Alkylgruppe mit 1 bis 30 Kohlenstoffatomen, eine Phenylgruppe oder eine Phenoxygruppe darstellen.

5. Klebefolie umfassend ein in einem organischen Lösemittel lösliches Polyimid (A), ein Epoxidharz (B) und einen thermisch leitfähigen Füllstoff (C), wobei ein in einem organischen Lösemittel lösliches Polyimid (A) umfassend eine Struktur, welche durch die folgende allgemeine Formel (1) dargestellt ist als eine Komponente, die von einem Diamin abgeleitet ist, wobei der Anteil eines thermisch leitfähigen Füllstoffes (C) in der Folie nicht weniger als 60 Vol.-% beträgt, wobei der thermisch leitfähige Füllstoff (C) zwei oder mehr Füllstoffe, die sich in dem durchschnittlichen Partikeldurchmesser unterscheiden und mindestens einen Füllstoff mit einem durchschnittlichen Partikeldurchmesser von 6 µm oder mehr und 15 µm oder weniger und einen Füllstoff mit einem durchschnittlichen Partikeldurchmesser von 30 µm oder mehr enthält, wobei der Anteil des thermisch leitfähigen Füllstoffes mit einem durchschnittlichen Partikeldurchmesser von 30 µm oder mehr nicht weniger als 10 Vol.-% und nicht mehr als 35 Vol-% beträgt, und der durchschnittliche Partikeldurchmesser durch eine Methode des direkten Beobachtens der Partikel mit einem REM (Rasterelektronenmikroskop) oder einem TEM (Transmissionselektronenmikroskop) gemessen und Durchschnittszahl des Partikeldurchmessers berechnet wird 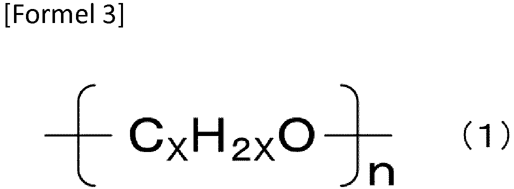 wobei in der allgemeinen Formel (1) X eine Ganzzahl von 1 bis einschließlich 10 darstellt und n eine Ganzzahl von 1 bis einschließlich 20 darstellt.

6. Klebefolie nach Anspruch 5, wobei der thermisch leitfähige Füllstoff (C) einen Füllstoff enthält, damit der gemessene pH-Wert, wenn 10 g des thermisch leitfähigen Füllstoffes zu 100 g Wasser hinzugegeben werden, nicht mehr als 6,0 ist.

7. Klebefolie nach Anspruch 5 oder 6, wobei der thermisch leitfähige Füllstoff (C) Aluminiumoxid beinhaltet.

8. Klebefolie nach einem der Ansprüche 5 bis 7, wobei das in einem organischen Lösemittel lösliche Polyimid (A) einen Diaminrest aufweist, der durch die folgende Formel (2) dargestellt ist: 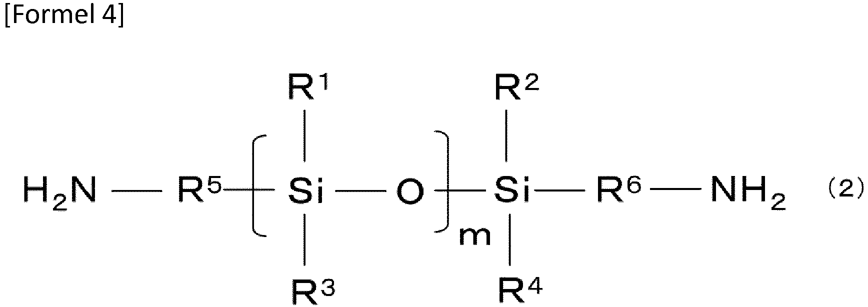 wobei in der allgemeinen Formel (2) m einen Bereich von 1 bis 30 darstellt. Darüber hinaus können R⁵ und R⁶ gleich oder unterschiedlich sein und eine Alkylengruppe mit 1 bis 30 Kohlenstoffatomen oder eine Phenylengruppe darstellen. R¹ bis R⁴ können jeweils gleich oder unterschiedlich sein und eine Alkylgruppe mit 1 bis 30 Kohlenstoffatomen, eine Phenylgruppe oder eine Phenoxygruppe darstellen.

9. Gehärtetes Produkt einer Klebstoffzusammensetzung gemäß einem der Ansprüche 1 bis 4 oder aus einer Klebefolie nach einem der Ansprüche 5 bis 8.

10. Halbleitervorrichtung umfassend ein gehärtetes Produkt einer Klebstoffzusammensetzung nach einem der Ansprüche 1 bis 4 oder einer Klebefolie nach einem der Ansprüche 5 bis 8.

## Revendications

1. Composition adhésive contenant un polyimide soluble dans un solvant organique (A), une résine époxy (B) et une charge thermoconductrice (C), un polyimide soluble dans un solvant organique (A) contenant une structure représentée par la formule générale (1) suivante en tant que composant dérivé d'une diamine, et la teneur d'une charge thermoconductrice (C) dans la composition adhésive étant d'au moins 60% en volume, la charge thermoconductrice (C) comporte deux charges ou plus qui diffèrent par le diamètre moyen de particules et contient au moins une charge ayant un diamètre moyen de particules compris entre 6 µm et 15 µm et une charge ayant un diamètre moyen de particules supérieur ou égal à 30 µm, la teneur de la charge thermoconductrice ayant un diamètre moyen de particules supérieur ou égal à 30 µm est d'au moins 10% en volume et d'au plus 35% en volume, et le diamètre moyen de particules est mesuré par une méthode d'observation directe des particules avec un SEM (microscope électronique à balayage) ou un TEM (microscope électronique à transmission) et de calcul d'une moyenne en nombre du diamètre de particules 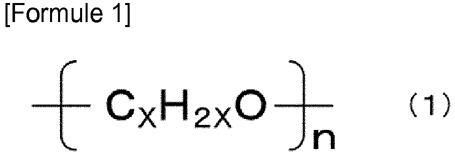 où dans la formule générale (1), X représente un nombre entier allant de 1 à 10 inclus et n représente un nombre entier allant de 1 à 20 inclus.

2. Composition adhésive selon la revendication 1, dans laquelle la charge thermoconductrice (C) comporte une charge dans laquelle le pH du liquide préparé lorsque 10 g de la charge thermoconductrice sont ajoutés à 100 g d'eau est d'au plus 6,0.

3. Composition adhésive selon la revendication 1 ou 2, dans laquelle la charge thermoconductrice (C) comporte de l'alumine.

4. Composition adhésive selon l'une quelconque des revendications 1 à 3, dans laquelle le polyimide soluble dans un solvant organique (A) a un résidu d'une diamine représenté par la formule générale (2) suivante : 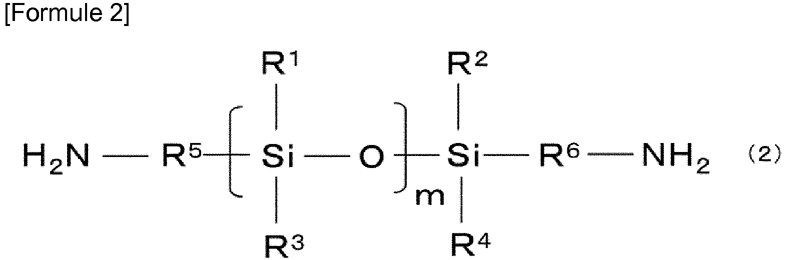 où dans la formule générale (2), m représente une plage allant de 1 à 30. De plus, R⁵ et R⁶ peuvent être identiques ou différents et représentent un groupe alkylène ayant 1 à 30 atome(s) de carbone ou un groupe phénylène. R¹ à R⁴ peuvent chacun être identiques ou différents et représentent un groupe alkyle ayant 1 à 30 atome(s) de carbone, un groupe phényle ou un groupe phénoxy.

5. Feuille adhésive contenant un polyimide soluble dans un solvant organique (A), une résine époxy (B) et une charge thermoconductrice (C), un polyimide soluble dans un solvant organique (A) contenant une structure représentée par la formule générale (1) suivante en tant que composant dérivé d'une diamine, la teneur d'une charge thermoconductrice (C) dans la feuille étant d'au moins 60% en volume, la charge thermoconductrice (C) comporte deux charges ou plus qui diffèrent par le diamètre moyen de particules et contient au moins une charge ayant un diamètre moyen de particules compris entre 6 µm et 15 µm et une charge ayant un diamètre moyen de particules supérieur ou égal à 30 µm, la teneur de la charge thermoconductrice ayant un diamètre moyen de particules supérieur ou égal à 30 µm est d'au moins 10% en volume et d'au plus 35% en volume, et le diamètre moyen de particules est mesuré par une méthode d'observation directe des particules avec un SEM (microscope électronique à balayage) ou un TEM (microscope électronique à transmission) et de calcul d'une moyenne en nombre du diamètre de particules 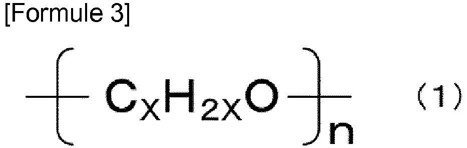 où dans la formule générale (1), X représente un nombre entier allant de 1 à 10 inclus et n représente un nombre entier allant de 1 à 20 inclus.

6. Feuille adhésive selon la revendication 5, dans laquelle la charge thermoconductrice (C) comporte une charge dans laquelle le pH mesuré lorsque 10 g de la charge thermoconductrice sont ajoutés à 100 g d'eau est d'au plus 6,0.

7. Feuille adhésive selon la revendication 5 ou 6, dans laquelle la charge thermoconductrice (C) comporte de l'alumine.

8. Feuille adhésive selon l'une quelconque des revendications 5 à 7, dans laquelle le polyimide soluble dans un solvant organique (A) a un résidu d'une diamine représenté par la formule générale (2) suivante : 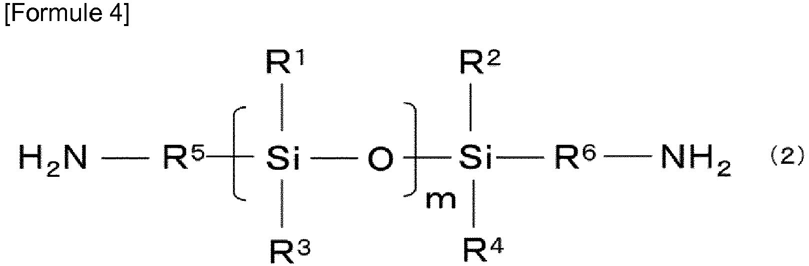 où dans la formule générale (2), m représente une plage allant de 1 à 30. De plus, R⁵ et R⁶ peuvent être identiques ou différents et représentent un groupe alkylène ayant 1 à 30 atome(s) de carbone ou un groupe phénylène. R¹ à R⁴ peuvent chacun être identiques ou différents et représentent un groupe alkyle ayant 1 à 30 atome(s) de carbone, un groupe phényle ou un groupe phénoxy.

9. Produit durci d'une composition adhésive selon l'une quelconque des revendications 1 à 4 ou d'une feuille adhésive selon l'une quelconque des revendications 5 à 8.

10. Dispositif à semi-conducteur comprenant un produit durci d'une composition adhésive selon l'une quelconque des revendications 1 à 4 ou d'une feuille adhésive selon l'une quelconque des revendications 5 à 8.
